# EUROPÄISCHE PATENTSCHRIFT

(11) **EP 3 766 109 B1**
(45) Veröffentlichungstag und Bekanntmachung des Hinweises auf die Patenterteilung: **30.08.2023**
(21) Anmeldenummer: 19711863.1
(22) Anmeldetag: 13.03.2019
(51) Int. Cl.: H10N 30/853, H10N 30/045, H10N 30/87, H10N 30/50, H10N 30/20, B81B 3/00

(54) **FERROELEKTRISCHES MATERIAL, MEMS-BAUTEIL MIT DIESEM MATERIAL, MEMS-VORRICHTUNG, SOWIE HERSTELLUNGSVERFAHREN**
FERROELECTRIC MATERIAL, MEMS COMPONENT COMPRISING THIS MATERIAL, MEMS DEVICE, AND PRODUCTION METHOD
MATÉRIAU FERROÉLECTRIQUE, COMPOSANT MEMS DOTÉ DUDIT MATÉRIAU, DISPOSITIF MEMS ET PROCÉDÉ DE FABRICATION

(30) Priorität: 13.03.2018 DE 102018203812
(43) Veröffentlichungstag der Anmeldung: 20.01.2021
(73) Patentinhaber: Fraunhofer-Gesellschaft zur Förderung der angewandten Forschung e.V., 80686 München (DE); Christian-Albrechts-Universität zu Kiel, 24118 Kiel (DE)
(72) Erfinder: WAGNER, Bernhard, 25524 Itzehoe (DE); LOFINK, Fabian, 25524 Itzehoe (DE); KADEN, Dirk, 25524 Itzehoe (DE); FICHTNER, Simon, 25524 Itzehoe (DE)
(74) Vertreter: Zimmermann, Tankred Klaus
(86) Internationale Anmeldenummer: PCT/EP2019/056275
(87) Internationale Veröffentlichungsnummer: WO 2019/175236

(56) Entgegenhaltungen:
- EP-A1- 3 216 894
- US-A1- 2008 296 529

## Beschreibung

### Technisches Gebiet

Ausführungsbeispiele gemäß der Erfindung beziehen sich auf ein ferroelektrisches Material, ein MEMS-Bauteil mit einem ferroelektrischen Material, eine MEMS-Vorrichtung mit einem ersten MEMS-Bauteil, ein Verfahren zur Herstellung eines MEMS-Bauteils und ein Verfahren zur Herstellung eines CMOS-kompatiblen MEMS-Bauteils.

### Hintergrund der Erfindung

Piezoelektrische MEMS Aktuatoren bieten, etwa gegenüber elektrostatisch angetriebenen Bauteilen, deutlich höhere Kräfte. Nichts desto trotz sind auch diese Kräfte, insbesondere für nicht-resonante Bewegungen, oftmals unzureichend. Mittels piezoelektrischen Multilagen ließen sich jedoch theoretisch beliebig große Kräfte in die jeweiligen Bauteile einkoppeln. Die bislang zur Verfügung stehenden Piezoelektrika, wie etwa Blei-Zirkonat-Titanat (PZT) oder Aluminiumnitrid (AIN) eignen sich allerdings nur eingeschränkt für piezoelektrische MEMS-Mehrlagensysteme, so dass die Überführung in eine kommerzielle Verwertung entsprechender Bauteile aktuell noch nicht erfolgsversprechend ist.

Ferroelektrische Materialien sind eine Variante von piezoelektrischen Materialen, welche sich durch eine räumlich drehbare elektrische Polarisation P auszeichnet, deren Richtung durch ein externes elektrisches Feld E bestimmt werden kann. Je nach Ausrichtung der Polarisation gegenüber dem wirkenden elektrischen Feld geht zudem eine Ausdehnung oder Kontraktion des Materials einher (piezoelektrischer Effekt). Dieser Effekt lässt sich in der Aktuatorik einsetzen. In der Mikrosystemtechnik wird dazu beispielsweise ein Plattenkondensator mit ferroelektrischem Dielektrikum auf einer passiven Schicht abgeschieden und strukturiert. Die passive Schicht kann etwa die Membran eines Ultraschallwandlers oder die eines Lautsprechers sein. Als Folge der Querkontraktion bzw. -Expansion des ferroelektrischen Materials bei angelegter elektrischer Spannung U wird hierbei, je nach Polarisationsrichtung, eine Druck- oder Zugspannung innerhalb des Substrats erzeugt und dieses damit verformt. Die der Verformung zugrunde liegende mechanische Kraft ist durch die piezoelektrischen Koeffizienten des Materials, dessen Polarisationsrichtung sowie durch die zur Verfügung stehende elektrische Spannung gegeben [1].

Eine Möglichkeit die Kraft für eine feste elektrische Spannung zu steigern besteht in der Verwendung eines Mehrlagensystems. Bei Verwendung von n-Lagen piezoelektrischen Materials mit betragsweise identischen piezoelektrischen Koeffizienten, über denen jeweils die verfügbare elektrische Spannung angelegt ist, lässt sich die resultierende Kraft um bis zu einem Faktor n steigern [2]. Die tatsächlich erreichbare Kraft hängt dabei entscheidend von der jeweiligen Ausrichtung der Materialpolarisation relativ zum angelegten elektrischen Feld ab. Idealerweise sind elektrisches Feld und Polarisation in allen piezoelektrischen Schichten auf derselben Seite der neutralen Ebene (auch neutrale Faser genannt) des Schichtsystems entweder parallel oder anti-parallel zueinander ausgerichtet. In diesem Fall tragen alle Schichten gleichgerichtet zur Gesamtkraft bei, diese ist damit maximal.

Makroskopische ferroelektrische Multilagenaktuatoren werden etwa bereits in KraftstoffEinspritzpumpen industriell angewendet [3]. In der mikrosystemtechnischen Aktuatorik werden ferroelektrische Mehrlagensysteme, trotz ihrer offensichtlichen Vorteile, bisher weitestgehend nur von akademischer Seite untersucht (z. B. [4], [5]). Dies liegt daran, dass bereits die Integration einer ferroelektrischen Einzellage (i.d.R. aus PZT) in die MEMS-Produktion eine nur mit großem technologischem Aufwand zu meisternde Herausforderung ist - etwa hinsichtlich Diffusion, Temperaturbudget und Strukturierung des Materials. Selbst wenn eine Integration von Mehrlagen-PZT in die MEMS-Technologie in Zukunft zur Verfügung stünde, bliebe das Material, neben weiterer Nachteile, nicht CMOS-kompatibel und nicht geeignet für eine elektrisch bipolare Aktuation.

Trotz deutlich geringerer piezoelektrischer Koeffizienten werden daher mitunter nichtferroelektrische Materialien wie AIN für eine Anwendung in piezoelektrischen Aktuatoren untersucht (z. B. [6], [7], [20], [21], [22], [23]). AIN ist ein pyroelektrisches Material, das heißt es zeigt, wie die Ferroelektrika, eine spontane elektrische Polarisation. Im Unterschied zu ferroelektrischen Materialien ist die Polarisation in AIN jedoch nicht durch ein externes elektrisches Feld räumlich drehbar. Für die Anwendung des Materials in piezoelektrischen Multilagen bedeutet dies aber einen nur schwer vertretbaren Mehraufwand in der Fertigung durch die Notwendigkeit zusätzlicher Isolationsschichten und Elektroden.

Alternativ besteht theoretisch die Möglichkeit einer einmaligen Einstellung der Materialpolarisation. Methoden dafür existieren zwar in Ansätzen, jedoch ist auch hier ein deutlicher fertigungstechnischer Mehraufwand zu betreiben, etwa durch die Notwendigkeit zusätzlicher Abscheideprozesse.

Im Folgenden werden diese kurz eingeführten bisherigen Lösungsansätze vertieft und abschließend motiviert, inwieweit die Entwicklung von ferroelektrischen Mischkristallen basierend auf AIN und den Nitriden von Übergangsmetallen piezoelektrische Multilagen-Bauteile ermöglicht, ohne dabei die Nachteile klassischer Ferroelektrika oder Pyroelektrika in Kauf nehmen zu müssen. In [24] und [25] sind bereits AIScN-Mischkristalle zur Verbesserung von piezoelektrischen Eigenschaften beschrieben, wobei kein Hinweis zu finden ist, wie mittels Scandium ein ferroelektrischer Mischkristall hergestellt werden kann.

Eine weitere denkbare Anwendung ferroelektrischer Multilagen ist eine Bauteilintrinsische Ladungsverstärkung, wie sie für Sensorkonzepte von Bedeutung ist, welche ihre Eingangsgröße piezoelektrisch in elektrische Ladungen umsetzen (alternativ zur Umsetzung in elektrische Spannungen). Dadurch können die Anforderungen an einen externen Ladungsverstärker reduziert werden. Ebenso von Vorteil kann eine solche Ladungsverstärkung in Mikrogeneratoren sein. Die im Folgenden vorgestellten Lösungsansätze für Aktuatoren ließen sich direkt ebenso auf die angesprochene Ladungsverstärkung anwenden. Der Dualismus der beiden Konzepte spiegelt dabei die beiden Richtungen des piezoelektrischen Effekts (direkt und invers) wieder.

Zur Umsetzung von piezoelektrischen Mehrlagensystemen für Aktuatoren in der Mikrosystemtechnik sind vier allgemeine, in wesentlichen Aspekten verschiedene Ansätze, denkbar. Ziel ist dabei jeweils, über jeder Einzellage die maximal zur Verfügung stehende elektrische Feldstärke (= U_{E}/Dicke einer Einzellage) wirken zu lassen sowie alle Schichten auf derselben Seite der neutralen Ebene mit demselben Vorzeichen zur Kraft beitragen zu lassen. Die im Folgenden vorgestellten bisherigen Lösungsansätze folgen direkt aus z. B. in [2] gemachten Überlegungen.

Für piezoelektrische Sensoren und Generatoren gibt es die Möglichkeit einer Spannungsverstärkung durch eine Reihenschaltung mehrerer gleicher piezoelektrischer Kondensatorstrukturen oder durch eine Erhöhung der Schichtdicke des Piezoelektrikums. Beispielsweise für Messkonzepte, welche das Ausgangssignal eines Sensors mittels Ladungsverstärker auslesen, hätte dieser Ansatz jedoch keinen direkten Vorteil. Genauso, wie eine Reihenschaltung für eine bauteilintrinsische Spannungsverstärkung sorgt, lässt sich allerdings mittels parallel geschalteten piezoelektrischen Kondensatoren eine intrinsische Ladungsverstärkung realisieren. Um dies in einem Mehrlagensystem zu realisieren, müssten beispielsweise allerdings die im Folgenden vorgestellten Lösungsansätze zur Anwendung kommen, mit den jeweiligen Nachteilen. Ziel ist hierbei stets eine Ladungskompensation zwischen benachbarten Kondensatoren zu vermeiden. Dies stellt wiederum Ansprüche an die Polarisationsrichtung des piezoelektrischen Materials.

Klassische Ferroelektrika, etwa PZT, lassen sich ohne zusätzliche Isolationsschichten zu effektiven Multilagenaktuatoren zusammenfügen, da dieser Materialklasse eine Ausrichtung seiner elektrischen Polarisation entlang der Feldrichtung externer elektrischer Felder inhärent ist. Neben der Möglichkeit, beide Seiten einer passiven Schicht mit aktiven piezoelektrischen Schichten zu versehen, kann es der Einfachheit halber von Vorteil sein, diese nur einseitig zu beschichten oder die Struktur ausschließlich aus einer piezoelektrischen Multilage nebst Elektroden zu konstruieren, d. h. ohne passive Schicht. In jedem Fall muss für die Wahl einer geeigneten Polarisation die Lage der neutralen Ebene beachtet werden. Schichten oberhalb dieser Ebene müssen ihre Kraft jeweils mit dem entgegengesetzten Vorzeichen einkoppeln, wie darunterliegende, wenn eine Biegebewegung induziert werden soll.

Trotz dieses möglichst einfachen Aufbaus besitzen die bisher in der Mikrosystemtechnik eingesetzten Ferroelektrika, welche im Wesentlichen PZT-basiert sind, einige entscheidende Nachteile:
- Notwendige Abscheidetemperaturen von größer 500°C und das enthaltene Blei machen das Material inkompatibel mit der CMOS-Fertigung.
- Die Gefahr elektrischer Durchbrüche begrenzt die maximal einsetzbare elektrische Feldstärke und damit die resultierende Kraft.
- Der Zusammenhang zwischen Kraft und angelegtem elektrischen Feld ist um den Nullpunkt des Feldes stark nicht-linear. Die Kraft bzw. Dehnung zeigt zudem über weite Strecken dasselbe Vorzeichen. Um dennoch eine näherungsweise harmonische Oszillation der antreibenden Kraft zu gewährleisten ist daher ein Spannungsoffset notwendig. Im Zusammenhang mit einer geringen Durchbruchfeldstärke schränkt dies die maximal zur Verfügung stehende Amplitude der antreibenden Kraft weiter ein.

- Die intrinsische mechanische Verspannung der ferroelektrischen Schichten ist nur bedingt beeinflussbar.
- Die dielektrischen Verluste und die während des Betriebs auftretenden Leckströme sind deutlich größer als in einigen anderen Dielektrika, wie etwa AIN.

Rein pyroelektrische, d. h. explizit nicht ferroelektrische Materialien wie reines AIN lassen sich CMOS kompatibel abscheiden. Sie können so hergestellt werden, dass die elektrische Durchbruchsfeldstärke deutlich höhere Werte als in klassischen Ferroelektrika erreicht und zudem nur geringe elektrische Verluste wirken. Darüber hinaus ist der Zusammenhang zwischen elektrischem Feld und resultierender Kraft in guter Näherung linear. Dies erlaubt insbesondere eine effiziente Anregung mit bipolaren elektrischen Spannungen. Da die Polarisation jedoch nachträglich nicht geändert werden kann, wird diese allein während der Herstellung des Materials definiert. In mittels ein und desselben Prozesses hergestellten Mehrlagensystemen zeigt die Polarisation aller Schichten somit in die gleiche Richtung, idealerweise senkrecht zum Substrat. Um einen effektiven Antrieb zu gewährleisten, muss daher auch das anregende elektrische Feld für alle Einzellagen in dieselbe Richtung zeigen. Daher ist es notwendig, die einzelnen Kondensatorstrukturen der Multilagen elektrisch zu trennen. Der wesentliche dadurch entstehende Nachteil gegenüber dem Einsatz von Ferroelektrika besteht in der Notwendigkeit mindestens zweier zusätzlicher Schichten, nämlich eines Isolators und einer weiteren Elektrode pro piezoelektrischer Schicht. Deren Abscheidung und Strukturierung bedeutet einen deutlich höheren Fertigungsaufwand. Der Verzicht auf eine entsprechende Isolationsschicht oder ein möglicher Kurzschluss über die Isolationsschicht hinweg hätten ein vollständiges Bauteilversagen zur Folge. Prinzipiell lassen sich mithilfe dieses Ansatzes auch beidseitig aktiv beschichtete passive Schichten oder Schichtsysteme ohne passive Schicht herstellen.

Ein Bimorph ermöglicht den Einsatz einer nicht-ferroelektrischen Doppellage ohne zusätzliche elektrische Isolation. Voraussetzung für einen effizienten Antrieb ist dabei, dass sich die beiden piezoelektrischen Schichten auf gegenüberliegenden Seiten der neutralen Ebene des Aktuators befinden. Die Schichten können sich dabei eine Elektrodenlage teilen oder durch eine dazwischenliegende passive Schicht räumlich getrennt sein. Die Anzahl der piezoelektrischen Schichten ist auf n = 2 begrenzt.

Die Polarisation in nicht-ferroelektrischen Pyroelektrika, wie etwa AIN, wird während der Herstellung des Materials fest eingeprägt. Optimales piezoelektrisches Verhalten liegt vor, wenn die elektrische Polarisation ausschließlich senkrecht zum Substrat ausgerichtet ist. Die Notwendigkeit einer Isolationsschicht zwischen den einzelnen Kondensatoreinheiten einer Multilage fällt dann weg, wenn Schichten mit zueinander antiparalleler Polarisation alternierend hergestellt und verwendet werden können. Eine dafür notwendige irreversible Einstellung der Polarisation könnte etwa durch die Bereitstellung einer geeigneten Zwischenschicht oder Startschicht erfolgen [8]. Des Weiteren konnte gezeigt werden, dass auch eine Dotierung, etwa mit Sauerstoff oder Germanium [9, 10], die Einstellung der Polarisationsrichtung ermöglicht. Diese Ansätze sind jedoch noch weit entfernt von der Anwendungsreife. Zudem muss für eine optimale Funktion sichergestellt werden, dass eine vollständige Polarisationsinversion gelingt, da diese nachträglich nicht mehr einstellbar ist. Die damit verbundene Komplexität sowie die Notwendigkeit zusätzlich zu entwickelnder Prozesse für Mehrlagensysteme müssen als gewichtiger Nachteil dieses Ansatzes aufgefasst werden. Im Gegensatz zu PZT bleibt die räumliche Ausrichtung der Polarisation jedoch, auch bei hohen elektrischen Feldstärken, konstant.

Die Druckschrift EP3216894A1 offenbart eine Dünnschicht X_{y}Al_{(1-y)}N, die vorzugsweise mit einer intrinsischen Zugspannung abgeschieden wird. Die Legierung enthält y Prozent der Verbindung XN, wobei X aus der Gruppe ausgewählt ist, die aus Yb, Ho, Dy, Lu, Tm, Tb und Gd besteht. Der Prozentsatz von XN liegt vorzugsweise im Bereich von 10-60%, und die Spannung liegt vorzugsweise im Bereich von 200MPa - 1,5GPa.

In Anbetracht dessen besteht ein Bedarf nach einem Konzept, das einen besseren Kompromiss zwischen größerer resultierender Kraft, Minimierung der Anzahl der notwendigen Isolationslagen und Elektrodenschichten sowie einer Reduzierung der benötigten Prozesse für das Abscheiden von piezoelektrischen Schichten einer Multilage bietet und darüber hinaus CMOS-Kompatibilität und einen linearen Zusammenhang zwischen elektrischer Spannung und resultierender Kraft ermöglicht.

### Zusammenfassung der Erfindung

Im folgenden werden ferroelektrische Schichten auch als piezoelektrische Schichten bezeichnet. Die Schichten gemäß der Ausführungsbeispiele müssen aber nicht notwendigerweise alle ferroelektrisch sein - es reicht, zum Beispiel, wenn einige der piezoelektrischen Schichten (z.B. jede zweite) ein ferroelektrisches Material enthalten und alle anderen nur ein piezoelektrisches Material. Denkbar ist z.B., dass einige Schichten einen abweichenden TM-Anteil oder eine abweichende mechanische Verspannung aufweisen, und damit nicht ferroelektrisch sind.

Ein Ausführungsbeispiel betrifft ein ferroelektrisches Material mit einem Mischkristall, der AIN und mindestens ein Nitrid eines Übergangsmetalls umfasst. Der Anteil des Nitrids des Übergangsmetalls muss so lange erhöht werden, bis eine Richtung einer anfänglichen oder spontanen Polarität des ferroelektrischen Materials durch Anlegen einer Umschaltspannung umgeschaltet werden kann und die Umschaltspannung unterhalb einer Durchbruchspannung des ferroelektrischen Materials liegt. In anderen Worten muss der Anteil des Nitrids des Übergangsmetalls so lange erhöht werden, bis eine Richtung einer anfänglichen oder spontanen Polarität des ferroelektrischen Materials durch Anlegen einer Umschaltspannung umgeschaltet werden kann und die Umschaltspannung unterhalb einer Durchbruchspannung des ferroelektrischen Materials liegt.

Dieses Ausführungsbeispiel des ferroelektrischen Materials mit einem Mischkristall basiert auf der Erkenntnis, dass eine Erhöhung des Anteils des Nitrids des Übergangsmetalls in dem Mischkristall des ferroelektrischen Materials dazu führt, dass die anfängliche oder spontane Polarität des ferroelektrischen Materials durch Anlegen einer Umschaltspannung umgeschaltet werden kann und somit die Richtung der anfänglichen oder spontanen Polarität des ferroelektrischen Materials nicht durch den Herstellungsprozess bestimmt wird, sondern noch nachträglich abgeändert werden kann. So weist der Mischkristall beispielsweise zunächst eine anfängliche oder spontane Polarität auf, deren Richtung mittels der Umschaltspannung geändert werden kann. So kann beispielsweise die Richtung der Polarität um 180° gedreht werden oder eine Richtung einer anfänglichen Polarität parallel zu einem elektrischen Feld, hervorgerufen mittels der Umschaltspannung, ausgerichtet werden.

Wird das ferroelektrische Material in einem Mehrlagensystem verwendet, so können beispielsweise die ferroelektrischen Schichten der Multilage mit einem einzigen Prozess abgeschieden werden, da man nicht auf eine in situ Manipulation der Polarisationsrichtung angewiesen ist, sondern zunächst alle ferroelektrischen Schichten mit der gleichen Polarisation abgeschieden werden können und nachträglich beispielsweise die Polarisation einzelner ausgewählter ferroelektrischer Schichten durch Anlegen einer Umschaltspannung umgeschaltet werden können. Durch die Möglichkeit, die Polarität des ferroelektrischen Materials durch Anlegen einer Umschaltspannung noch nach dem Herstellungsprozess umschalten zu können, kann die notwendige Anzahl an Isolationslagen und Elektrodenschichten in einem Mehrlagensystem des ferroelektrischen Materials minimiert werden, da die Polarisation der einzelnen Schichten des ferroelektrischen Materials mithilfe einer Umschaltspannung so eingestellt werden kann, dass beispielsweise zwischen zwei Schichten des ferroelektrischen Materials nur eine Elektrodenschicht liegen muss, die sich beide Schichten, mit dem ferroelektrischen Material, teilen.

Somit ist festzuhalten, dass das ferroelektrische Material in der Verwendung eines Mehrlagensystems dazu führen kann, dass die ferroelektrischen Schichten der Mehrlage in einem einzigen Prozess abgeschieden werden können und die notwendige Anzahl an Isolationslagen und Elektrodenschichten durch ein Umschalten der Polarität einzelner ferroelektrischer Schichten minimiert werden kann.

Bei einem Ausführungsbeispiel weist das ferroelektrische Material eine mechanische Spannung auf. Die mechanische Spannung kann zum Beispiel durch die Zusammensetzung eines während der Herstellung verwendeten Gases eingestellt werden oder durch das Anlegen einer elektrischen Spannung während der Herstellung. Die mechanische Spannung liegt zwischen einem ersten Wert einer Druckspannung und einem zweiten Wert einer Zugspannung, wobei ein Absolutwert des ersten Wertes niedriger ist als ein Absolutwert des zweiten Wertes. Das bedeutet beispielsweise, dass die mechanische Spannung innerhalb einer ferroelektrischen Schicht mit dem ferroelektrischen Material hin zu mehr Zugspannung oder weniger Druckspannung eingestellt wird, damit die Umschaltspannung unterhalb der Durchbruchsspannung des ferroelektrischen Materials liegt. Der TM-Anteil (Anteil des Übergangsmetalls) und die mech. Spannung können über weite Strecken unabhängig voneinander eingestellt werden - haben aber beide einen Einfluss auf den Betrag der Umschaltspannung. Durch das Zusammenspiel zwischen TM-Anteil und der mechanischen Spannung verringert sich, zum Beispiel für eine Erhöhung der Zugspannung von ferroelektrischen Schichten mit dem ferroelektrischen Material der notwendige Anteil des Nitrids des Übergangsmetalls und im Fall von einer Erhöhung der Druckspannung kann sich, zum Beispiel, der notwendige Anteil des Nitrids des Übergangsmetalls vergrößern.

Bei einem Ausführungsbeispiel liegt die mechanische Spannung in einem Intervall von -600 MPa (erster Wert einer Druckspannung) bis 2000 MPa (zweiter Wert einer Zugspannung), wobei negative Werte Druckspannung und positive Werte Zugspannung bedeuten. Liegt die mechanische Spannung in dem Intervall von -600 MPa bis 2000 MPa, wie zum Beispiel in einem Intervall von -550 MPa bis 1500 MPa, von -500 MPa bis 1000 MPa oder von -450 MPa bis 900MPa, so wird, unter der Voraussetzung der TM-Anteil (Anteil des Übergangsmetalls) überschreitet eine gewisse Grenze, beispielsweise erreicht, dass die Umschaltspannung unterhalb der Durchbruchspannung liegt und somit das ferroelektrische Material bei Anlegen der Umschaltspannung nicht beschädigt wird. Der Bereich von -600 MPa bis 2000 MPa deckt, zum Beispiel, den Bereich ab, indem das Verhältnis zwischen der Druckspannung und der Zugspannung dahingegen optimiert ist, dass die Richtung der Polarität des ferroelektrische Materials bei Anlegen einer Umschaltspannung umgeschalten wird.

Bei einem Ausführungsbeispiel bleibt die Richtung der Polarität des ferroelektrischen Materials nach einem Entfernen der angelegten Umschaltspannung für eine große Zeitspanne erhalten. Das bedeutet, zum Beispiel, dass nach dieser Änderung der Richtung der Polarität des ferroelektrischen Materials die Richtung der Polarisation über lange Zeit konstant bleibt. Ist die ursprüngliche Richtung der Polarisation des ferroelektrischen Materials, vor dem Anlegen der Umschaltspannung, gewünscht, so muss an des ferroelektrische Material erneut die Umschaltspannung mit entgegengesetztem elektrischen Feld, als bei der vorrangegangenen Umschaltspannung, angelegt werden. Die Richtung der Polarität des ferroelektrischen Materials richtet sich entlang des elektrischen Feldes, das das ferroelektrische Material durchdringt und durch die Umschaltspannung hervorgerufen wird, aus.

Bei einem Ausführungsbeispiel bewirkt der gewählte Anteil des Nitrids des Übergangsmetalls, dass der Mischkristall ferroelektrisch wird. Durch die ferroelektrische Eigenschaft des Mischkristalls kann unter anderem die Polarität des Mischkristalls elektrisch z. B. durch Anlegen einer Umschaltspannung umgeschaltet werden. Das Umschalten der Polarität bedeutet beispielsweise, dass die Polarität des Mischkristalls vor Anlegen einer Umschaltspannung z. B. in eine Richtung innerhalb des Mischkristalls zeigt und nach Anlegen einer Umschaltspannung die Polarität des Mischkristalls in die entgegengesetzte Richtung bezogen auf die Polarisationsrichtung vor Anlegen der Umschaltspannung gerichtet ist. Somit wird die Polarität beispielsweise invertiert. Ein Umschalten der Polarität des ferroelektrischen Materials kann aber auch bedeuten, dass beispielsweise ein Großteil von Dipolmomenten des Mischkristalls (z. B. zwischen 50 % und 100 % der Dipole, zwischen 70 % und 100 % der Dipole oder zwischen 80 % und 100 % der Dipole wie z. B. 90 % der Dipole) sich entlang einer elektrischen Feldrichtung, erzeugt durch das Anlegen einer Umschaltspannung an den Mischkristall, orientiert, wobei vor Anlegen der Umschaltspannung an den Mischkristall ein Großteil der Dipolmomenten des Mischkristalls in entgegengesetzter Richtung bezüglich der Feldrichtung der nachträglich angelegten Umschaltspannung ausgerichtet war.

In einem Beispiel liegt das Verhältnis zwischen einer Anzahl an Übergangsmetall-Atomen zu einer Summe aus der Anzahl an Übergangsmetall-Atomen und einer Anzahl an Aluminiumatomen in einem Bereich ≥ 0,2 und ≤ 0,5. So kann beispielsweise das Verhältnis zwischen der Anzahl an Übergangsmetall-Atom zu der Summe aus der Anzahl an Übergangsmetall-Atomen und der Anzahl an Aluminiumatomen in einem Bereich zwischen 0,25 und 0,43 oder erfindungsgemäß zwischen 0,30 und 0,36 wie z. B. bei 0,36 liegen. Das Verhältnis hängt beispielsweise von dem Übergangsmetall ab. Das Verhältnis kann aber auch von der mechanischen Verspannung des ferroelektrischen Materials abhängen. Für unter Zugspannung stehende Schichten des ferroelektrischen Materials würde sich beispielsweise der notwendige Anteil des Nitrids des Übergangsmetalls verringern, im Falle von Druckspannung vergrößern. Außerdem kann das ferroelektrische Material bei Temperaturen unter 500°C (zum Beispiel, bei einer Temperatur zwischen 0°C und 500°C, wie 200°C, 240°C, 300°C, 360°C, 400°C oder 470°C) und unter anderem bleifrei abgeschieden werden, wodurch es CMOS-kompatibel ist.

In einem Ausführungsbeispiel umfasst das Übergangsmetall Scandium, Yttrium, Titan, Chrom, Niob oder eine beliebige Kombination dieser. Mithilfe dieser speziellen Übergangsmetalle kann beispielsweise erzielt werden, dass durch Anlegen einer Umschaltspannung an den Mischkristall die Polarität des ferroelektrischen Materials umgeschaltet wird.

Ein Ausführungsbeispiel betrifft ein Verfahren, mit dem Schritt Bereitstellen eines Mischkristalls mit einer anfänglichen oder spontanen Polarität. Der Mischkristall umfasst AIN und mindestens ein Nitrid eines Übergangsmetalls. Der Anteil des Nitrids des Übergangsmetalls ist z. B. so gewählt, dass eine Richtung der anfänglichen oder spontanen Polarität des ferroelektrischen Materials durch Anlegen einer Umschaltspannung umschaltbar ist. Die Umschaltspannung liegt z. B. unterhalb einer Durchbruchspannung des ferroelektrischen Materials liegt. Das Verfahren weist ferner den Schritt Anlegen einer Umschaltspannung an den Mischkristall auf, so dass die Richtung der anfänglichen oder spontanen Polarität des Mischkristalls umgekehrt wird.

Ein Ausführungsbeispiel betrifft ein MEMS-Bauteil mit einem ferroelektrischen Material. Durch die Verwendung des ferroelektrischen Materials, beispielsweise gemäß einem der Ausführungsbeispiele, können vielfältige MEMS-Bauteile gefertigt werden, bei denen die Eigenschaft des ferroelektrischen Materials, dass durch Anlegen einer Umschaltspannung die Polarität umgeschaltet werden kann, genutzt werden kann. Des Weiteren wird die Fertigung von MEMS-Bauteilen, beispielsweise bestehend aus mehreren Schichten des ferroelektrischen Materials, durch das ferroelektrische Material vereinfacht, da alle Schichten mit dem selben Prozess hergestellt werden können und anschließend durch Anlegen einer Umschaltspannung die Polarität einzelner, gleichzeitig oder nacheinander auch von mehreren, Schichten umgeschaltet werden kann.

Bei einem Ausführungsbeispiel umfasst das MEMS-Bauteil eine erste ferroelektrische Schicht, die das ferroelektrische Material umfasst, eine erste Elektrode, die auf einer ersten Oberfläche der ersten ferroelektrischen Schicht angeordnet ist, und eine zweite Elektrode, die auf einer zweiten Oberfläche der ersten ferroelektrischen Schicht angeordnet ist. Die zweite Oberfläche liegt dabei beispielsweise der ersten Oberfläche gegenüber. Dies ist ein Beispiel für ein Mehrlagensystem aus dem ferroelektrischen Material. Über die erste Elektrode und die zweite Elektrode kann eine Umschaltspannung an die erste ferroelektrische Schicht angelegt werden. Durch das Anlegen einer Umschaltspannung kann die Polarität der ersten ferroelektrischen Schicht umgeschaltet werden. Wird dieses MEMS-Bauteil bei einer Spannung geringer als die Umschaltspannung betreiben, so ändert sich die Richtung der Polarität der ersten ferroelektrischen Schicht nicht. Wird das MEMS-Bauteil mit einer geringeren Spannung als der Umschaltspannung betrieben, so kann es beispielsweise die Funktion eines Aktuators haben und beispielsweise den zugeführten elektrischen Strom durch das Anlegen der Spannung an der ersten und der zweiten Elektrode in mechanische Bewegung umwandeln und beispielsweise seine Ausdehnung in eine Raumrichtung entweder verkürzen oder verlängern.

Bei einem Ausführungsbeispiel weist das MEMS-Bauteil eine zweite ferroelektrische Schicht, die auf der ersten Elektrode gegenüber der ersten ferroelektrischen Schicht angeordnet ist, und eine dritte Elektrode, die auf einer ersten Oberfläche der zweiten ferroelektrischen Schicht angeordnet ist, auf. Die erste Oberfläche der zweiten ferroelektrischen Schicht ist dabei der ersten Elektrode abgewandt angeordnet. D. h. die zweite Elektrode und die dritte Elektrode begrenzen einen Block, bestehend aus einer ersten ferroelektrischen Schicht einer ersten Elektrode und einer zweiten ferroelektrischen Schicht, auf gegenüberliegenden Seiten, wobei die erste Elektrode zwischen der ersten ferroelektrischen Schicht und der zweiten ferroelektrischen Schicht so angeordnet ist, dass die zweite ferroelektrische Schicht die erste Elektrode von der dritten Elektrode trennt und die erste ferroelektrische Schicht die erste Elektrode von der zweiten Elektrode trennt. Die erste ferroelektrische Schicht und die zweite ferroelektrische Schicht weisen ferroelektrisches Material wie hierin beschrieben auf. Das Abscheiden der ersten ferroelektrischen Schicht und der zweiten ferroelektrischen Schicht für das Multilagen-MEMS-Bauteil kann mit einem einzigen Prozess durchgeführt werden. So kann beispielsweise zunächst die zweite Elektrode in Form eines Quaders aus leitfähigem Material hergestellt werden und anschließend auf eine Oberfläche der zweiten Elektrode die erste ferroelektrische Schicht so aufgebracht werden, dass die Polarität der ersten ferroelektrischen Schicht senkrecht zu der berührenden Oberfläche der zweiten Elektrode zeigt. Die Polarität der ersten ferroelektrischen Schicht kann beispielsweise entweder zu der Oberfläche der zweiten Elektrode, die zwischen der zweiten Elektrode und der ersten ferroelektrischen Schicht liegt, zeigen oder von dieser Oberfläche weg. Die erste ferroelektrische Schicht kann beispielsweise die Form eines Quaders haben. Auf einer Oberfläche der ersten ferroelektrischen Schicht, gegenüber der zweiten Elektrode, kann beispielsweise die erste Elektrode in Form eines Quaders aus elektrisch leitfähigem Material aufgebracht werden und auf einer Oberfläche der ersten Elektrode gegenüber der berührenden Oberfläche zur ersten ferroelektrischen Schicht kann ein Quader aus ferroelektrischem Material aufgebracht werden, der beispielsweise die zweite ferroelektrische Schicht darstellt. Die Polarität dieser zweiten ferroelektrischen Schicht sollte dabei senkrecht zu der Fläche zwischen der ersten Elektrode und der zweiten ferroelektrischen Schicht stehen. Dadurch, dass die zweite ferroelektrische Schicht mit dem gleichen Prozess oder im gleichen Prozess wie die erste ferroelektrische Schicht abgeschieden werden kann, hat die zweite ferroelektrische Schicht beispielsweise die gleiche Polarität wie die erste ferroelektrische Schicht. Auf einer Oberfläche der zweiten ferroelektrischen Schicht gegenüber der ersten Elektrode wird eine dritte Elektrode aufgebracht. Mithilfe der ersten Elektrode, zweiten Elektrode und/oder dritten Elektrode kann beispielsweise eine Spannung an die erste ferroelektrische Schicht und/oder zweite ferroelektrische Schicht angelegt werden. Hierdurch entsteht der Vorteil, dass beispielsweise durch Anlegen einer Umschaltspannung an die erste Elektrode und an die dritte Elektrode die Polarität der zweiten ferroelektrischen Schicht umgeschaltet werden kann. Durch das Umschalten der Polarität der zweiten ferroelektrischen Schicht zeigt die Polarität der zweiten ferroelektrischen Schicht in entgegengesetzte Richtung zu der Polarität der ersten ferroelektrischen Schicht. Wird in diesem Fall an die erste Elektrode, zweite Elektrode und dritte Elektrode eine Spannung angelegt, die geringer ist als die Umschaltspannung, so können sich beide ferroelektrischen Schichten gleichzeitig zusammenziehen oder ausdehnen. Durch die gegensätzliche Polarität der ersten ferroelektrischen Schicht und der zweiten ferroelektrischen Schicht erhöht sich die Kraft, mit der sich zum Beispiel ein MEMS-Bauteil verbiegen kann. Zudem wird zwischen der ersten ferroelektrischen Schicht und der zweiten ferroelektrischen Schicht nur eine Elektrode (z. B. die erste Elektrode) benötigt und nicht wie in bekannten Ausführungsbeispielen eines Mehrlagensystems mit rein piezoelektrischem Material, bei denen eine weitere Elektrode benötigt wird und dabei die beiden Elektroden durch eine Isolationsschicht getrennt werden müssen. Somit kann mit diesem MEMS-Bauteil die Anzahl an Isolationsschichten und Elektroden minimiert werden.

Bei einem Ausführungsbeispiel weist die erste Elektrode des MEMS-Bauteils eine erste Elektrodenschicht und eine zweite Elektrodenschicht auf. Zwischen der ersten und der zweiten Elektrodenschicht ist eine Isolationsschicht angeordnet, in der eine neutrale Ebene liegt. Bei diesem MEMS-Bauteil kann die erste ferroelektrische Schicht sowie die zweite ferroelektrische Schicht mit einem Prozess abgeschieden werden und durch das Multilagensystem erhöht sich die Kraft des MEMS-Bauteils. Durch die Einführung der Isolationsschicht kann die erste ferroelektrische Schicht unabhängig von der zweiten ferroelektrischen Schicht angesteuert werden. Hierfür kann beispielsweise die erste ferroelektrische Schicht durch Anlegen einer Spannung an die zweite Elektrode und die zweite Elektrodenschicht angesteuert werden und die zweite ferroelektrische Schicht durch Anlegen einer Spannung an die dritte Elektrode und die erste Elektrodenschicht. Weiter kann die zusätzliche Schicht (Isolationsschicht) z.B. als Trägermaterial während der Herstellung dienen.

Bei einem Ausführungsbeispiel weist die erste Elektrode des MEMS-Bauteils eine erste Elektrodenschicht und eine zweite Elektrodenschicht auf. Zwischen der ersten und der zweiten Elektrodenschicht ist eine passive Schicht angeordnet, in der eine neutrale Ebene liegt. Durch die passive Schicht kann beispielsweise die zweite ferroelektrische Schicht auf der einen Seite der neutralen Ebene eine andere Krafteinwirkung auf das MEMS-Bauteil haben als die erste ferroelektrische Schicht auf der anderen Seite der neutralen Ebene. Somit kann beispielsweise ein Biegen des MEMS-Bauteils und damit die Biegekraft des MEMS-Bauteils verstärkt werden.

Bei einem Ausführungsbeispiel hat das MEMS-Bauteil eine dritte ferroelektrische Schicht, die auf der dritten Elektrode, gegenüber der zweiten ferroelektrischen Schicht, angeordnet ist, eine vierte Elektrode, die auf einer ersten Oberfläche der dritten ferroelektrischen Schicht angeordnet ist, wobei die erste Oberfläche der dritten ferroelektrischen Schicht der dritten Elektrode abgewandt angeordnet ist, eine vierte ferroelektrische Schicht, die auf der zweiten Elektrode, gegenüber der ersten ferroelektrischen Schicht, angeordnet ist, und eine fünfte Elektrode, die auf einer ersten Oberfläche der vierten ferroelektrischen Schicht angeordnet ist. Die erste Oberfläche der vierten ferroelektrischen Schicht ist der zweiten Elektrode abgewandt angeordnet. Dieses MEMS-Bauteil weist vier ferroelektrische Schichten auf. Je mehr Lagen das MEMS-Bauteil aufweist, desto größer wird die Kraft des MEMS-Bauteils. Durch die Verwendung des speziell hier beschriebenen ferroelektrischen Materials kann die Polarität der einzelnen ferroelektrischen Schichten somit durch Anlegen einer Umschaltspannung umgeschaltet werden, dass die Kräfte der einzelnen ferroelektrischen Schichten so zusammenwirken, dass die Gesamtkraft des MEMS-Bauteils sehr groß wird. Zudem werden bei diesem Mehrlagensystem keine zusätzlichen Isolationsschichten benötigt. Die erste Elektrode, zweite Elektrode und dritte Elektrode können jeweils von zwei ferroelektrischen Schichten verwendet werden. Dadurch, dass die Polarität einzelner ferroelektrischer Schichten nach der Herstellung des MEMS-Bauteils noch verändert werden kann, können die ferroelektrischen Schichten der Multilage mit einem einzigen Prozess oder in einem einzigen Prozess abgeschieden werden.

Bei einem Ausführungsbeispiel ist eine passive Schicht an die zweite Elektrode des MEMS-Bauteils angeordnet. Durch Verwendung dieses Mehrlagensystems kann die zusammenwirkende Kraft aus den einzelnen Kräften der einzelnen ferroelektrischen Schichten auf die passive Schicht gekoppelt werden. Dies kann dazu führen, dass die passive Schicht ausgelenkt wird.

Bei einem Ausführungsbeispiel ist die passive Schicht des MEMS-Bauteils mindestens auf einer Seite mit einem Substrat verbunden. Somit ist die passive Schicht beispielsweise auf einer Seite fest verankert und auf der gegenüberliegenden Seite frei beweglich. Durch diesen Aufbau wird die Wirkung des MEMS-Bauteils weiter erhöht, da nun die Auslenkung des MEMS-Bauteils nur noch auf der frei beweglichen Seite der passiven Schicht erfolgen kann und somit auf dieser Seite eine höhere Auslenkung erzielt werden kann, als wenn das MEMS-Bauteil auf beiden Seiten ausgelenkt wird. Weiter bewirkt die Verankerung (Verbindung des MEMS-Bauteils mit dem Substrat) z.B. eine räumliche Fixierung des Bauteils.

Bei einem Ausführungsbeispiel umfasst das MEMS-Bauteil einen Mehrlagen-MEMS-Aktuator, einen Mehrlagen-MEMS-Sensor oder einen Mehrlagen-MEMS-Generator. Durch die Verwendung des ferroelektrischen Materials in einem Mehrlagen-MEMS-Aktuator, einem Mehrlagen-MEMS-Sensor oder einem Mehrlagen-MEMS-Generator können diese kostengünstiger und effizienter hergestellt werden, da die ferroelektrischen Schichten in einem einzigen Prozess oder mit einem einzigen Prozess abgeschieden werden können und nachträglich die gewünschte Polarität der einzelnen ferroelektrischen Schichten eingestellt werden kann. Wenn das MEMS-Bauteil einen Mehrlagen-MEMS-Aktuator, einen Mehrlagen-MEMS-Sensor oder einen Mehrlagen-MEMS-Generator umfasst, so kann das MEMS-Bauteil zum Beispiel auch verschiedene Aufbau- und Verbindungstechniken ("packaging") aufweisen, wie zum Beispiel mindestens eine Aufhängung, mindestens eine Verbindung zu einem Substrat, mindestens eine Verbindung zu einer Membran, etc. und/oder Kombinationen dieser.

Bei einem Ausführungsbeispiel weist eine MEMS-Vorrichtung ein Substrat und ein erstes MEMS-Bauteil auf. Eine passive Schicht des MEMS-Bauteils ist dabei auslenkbar an dem Substrat angeordnet. Somit ist die passive Schicht beispielsweise auf einer Seite fest verankert und auf der gegenüberliegenden Seite frei beweglich. Durch diesen Aufbau wird die Wirkung des MEMS-Bauteils weiter erhöht, da nun die Auslenkung des MEMS-Bauteils nur noch auf der frei beweglichen Seite der passiven Schicht erfolgen kann und somit auf dieser Seite eine höhere Auslenkung erzielt werden kann, als wenn das MEMS-Bauteil auf beiden Seiten ausgelenkt wird.

Bei einem Ausführungsbeispiel weist die MEMS-Vorrichtung ein zweites MEMS-Bauteil auf. Die erste und die zweite passive Schicht bilden hierbei eine Gemeinschaft und die Elektroden und die ferroelektrischen Schichten des ersten und des zweiten MEMS-Bauteils sind parallel angeordnet. Mithilfe dieser MEMS-Vorrichtung wird die gemeinsame passive Schicht des ersten MEMS-Bauteils und des zweiten MEMS-Bauteils stärker ausgelenkt, da in dieser MEMS-Vorrichtung das erste MEMS-Bauteil und das zweite MEMS-Bauteil, die parallel zueinander angeordnet sind, so zusammenwirken, dass auf die gemeinsame passive Schicht eine stärkere Biegekraft ausgeübt wird, wodurch die auslenkbare Seite der MEMS-Vorrichtung stark ausgelenkt wird. Des Weiteren kann durch diesen Aufbau beispielsweise eine Torsion der gemeinsamen passiven Schicht hervorgerufen werden, wenn das erste MEMS-Bauteil, durch Anlegen einer Spannung, gegenphasig zu dem zweiten MEMS-Bauteil, an das ebenfalls eine Spannung angelegt ist, angeregt wird.

Ein weiteres Ausführungsbeispiel schafft ein Verfahren zur Herstellung eines MEMS-Bauteils. Das Verfahren umfasst ein Stapeln einer ersten Elektrode, einer ersten ferroelektrischen Schicht, einer zweiten Elektrode, einer zweiten piezoelektrischen Schicht und einer dritten Elektrode in dieser Reihenfolge. Die erste ferroelektrische Schicht und die zweite piezoelektrische Schicht weisen die gleiche Polarisationsrichtung auf und die erste ferroelektrische Schicht umfasst ferroelektrisches Material mit einem Mischkristall, der AIN und mindestens ein Nitrid eines Übergangsmetalls umfasst. Der Anteil des Nitrids des Übergangsmetalls ist so gewählt, dass die Polarität des ferroelektrischen Materials durch Anlegen einer Umschaltspannung umschaltbar ist. Die Umschaltspannung liegt unterhalb einer Durchbruchspannung des ferroelektrischen Materials. Das Verfahren weist ferner den folgenden Schritt auf: Anlegen einer Umschaltspannung an die erste Elektrode und an die zweite Elektrode. Die Polarisationsrichtung der ersten ferroelektrischen Schicht wird dadurch umgekehrt, so dass die Polarisationsrichtung der ersten ferroelektrischen Schicht umgekehrt wird (zum Beispiel, entgegengesetzt der Polarisationsrichtung der zweiten piezoelektrischen Schicht).

Ein weiteres Ausführungsbeispiel schafft ein Verfahren zur Herstellung eines MEMS-Bauteils, bei dem die erste Elektrode, die erste ferroelektrische Schicht, die zweite Elektrode, die zweite piezoelektrische Schicht und die dritte Elektrode auf einem Substrat gestapelt werden, und das Verfahren weist ferner folgenden Schritt auf:
Integrieren einer oder mehrerer Schaltungskomponenten einer integrierten Schaltung unter Verwendung eines CMOS-Prozesses in dem Substrat vor oder nach dem Stapeln der ersten Elektrode, der ersten ferroelektrischen Schicht, der zweiten Elektrode, der zweiten piezoelektrischen Schicht und der dritten Elektrode.

Die Verfahren basieren auf derselben Überlegung wie für das ferroelektrische Material, das MEMS-Bauteil, und die MEMS-Vorrichtung wie oben beschrieben.

Die Verfahren können im Übrigen durch alle Merkmale und Funktionalitäten ergänzt werden, die hierin auch im Hinblick auf das erfindungsgemäße ferroelektrische Material, das MEMS-Bauteil und die MEMS-Vorrichtung beschrieben sind.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

### Figurenkurzbeschreibung

Ausführungsbeispiele gemäß der vorliegenden Erfindung werden nachfolgend Bezug nehmend auf die beiliegenden Figuren näher erläutert. Es zeigen:
- Fig. 1a: eine schematische Darstellung eines ferroelektrischen Materials gemäß einem Ausführungsbeispiel der vorliegenden Erfindung;
- Fig. 1b: eine schematische Darstellung eines ferroelektrischen Materials mit angelegter Umschaltspannung gemäß einem Ausführungsbeispiel der vorliegenden Erfindung;
- Fig. 2: eine schematische Darstellung eines MEMS-Bauteils gemäß einem Ausführungsbeispiel der vorliegenden Erfindung;
- Fig. 3: eine schematische Darstellung eines MEMS-Bauteils mit zwei ferroelektrischen Schichten gemäß einem Ausführungsbeispiel der vorliegenden Erfindung;
- Fig. 4: eine schematische Darstellung eines MEMS-Bauteils, bei dem die erste Elektrode eine erste Elektrodenschicht und eine zweite Elektrodenschicht aufweist gemäß einem Ausführungsbeispiel der vorliegenden Erfindung;
- Fig. 5: eine schematische Darstellung eines MEMS-Bauteils mit vier ferroelektrischen Schichten gemäß einem Ausführungsbeispiel der vorliegenden Erfindung;
- Fig. 6: eine schematische Darstellung eines MEMS-Bauteils mit Substrat gemäß einem Ausführungsbeispiel der vorliegenden Erfindung;
- Fig. 7a: eine schematische Darstellung eines MEMS-Bauteils mit beliebiger Anzahl an ferroelektrischen Schichten und einem Substrat gemäß einem Ausführungsbeispiel der vorliegenden Erfindung;
- Fig. 7b: eine schematische Darstellung eines MEMS-Bauteils mit beliebiger Anzahl ferroelektrischer Schichten, einem Substrat und elektrischer Kontaktierung der Elektroden gemäß einem Ausführungsbeispiel der vorliegenden Erfindung;
- Fig. 7c: eine schematische Darstellung eines MEMS-Bauteils mit einer beliebigen Anzahl an ferroelektrischen Schichten gemäß einem Ausführungsbeispiel der vorliegenden Erfindung;
- Fig. 8a: eine schematische Darstellung einer MEMS-Vorrichtung gemäß einem Ausführungsbeispiel der vorliegenden Erfindung;
- Fig. 8b: eine schematische Darstellung einer MEMS-Vorrichtung mit zwei MEMS-Bauteilen gemäß einem Ausführungsbeispiel der vorliegenden Erfindung;
- Fig. 9: ein Blockdiagramm eines Verfahrens zur Herstellung eines MEMS-Bauteils gemäß einem Ausführungsbeispiel der vorliegenden Erfindung;
- Fig. 10a: ein Blockdiagramm eines Verfahrens zur Herstellung eines MEMS-Bauteils, verbunden mit einem Substrat mit einer integrierten Schaltung unter Verwendung eines CMOS-Prozesses, gemäß einem Ausführungsbeispiel der vorliegenden Erfindung;
- Fig. 10b: ein Blockdiagramm eines Verfahrens zur Herstellung eines MEMS-Bauteils, verbunden mit einem Substrat mit einer integrierten Schaltung unter Verwendung eines CMOS-Prozesses, gemäß einem Ausführungsbeispiel der vorliegenden Erfindung;
- Fig. 11a: ein Diagramm über die elektrische Polarisation eines ferroelektrischen Materials gemäß einem Ausführungsbeispiel der vorliegenden Erfindung;
- Fig. 11b: ein Diagramm zu dem mittleren Betrag des gemessenen Koerzitivfeldes über der mechanischen Verspannung einer ferroelektrischen Schicht gemäß einem Ausführungsbeispiel der vorliegenden Erfindung;
- Fig. 11c: ein Diagramm zu dem mittleren Betrag des gemessenen Koerzitivfeldes über den Sc Gehalt einer AIScN-Schicht gemäß einem Ausführungsbeispiel der vorliegenden Erfindung;
- Fig. 12: ein Diagramm zur ferroelektrischen Kraft einer ferroelektrischen Schicht mit einer Elektrodenfläche gemäß einem Ausführungsbeispiel der vorliegenden Erfindung;
- Fig. 13a: eine schematische Darstellung einer Einheitszelle eines Wurtzits eines ferroelektrischen Materials mit einer negativen Polarität gemäß einem Ausführungsbeispiel der vorliegenden Erfindung;
- Fig. 13b: eine schematische Darstellung einer Einheitszelle einer hexagonalen Struktur eines ferroelektrischen Materials mit keiner Polarität gemäß einem Ausführungsbeispiel der vorliegenden Erfindung;
- Fig. 13c: eine schematische Darstellung einer Einheitszelle eines Wurtzits eines ferroelektrischen Materials mit einer positiven Polarität gemäß einem Ausführungsbeispiel der vorliegenden Erfindung;
- Fig. 14a: schematische Darstellung eines ferroelektrischen Aktuators gemäß dem Stand der Technik;
- Fig. 14b: eine schematische Darstellung eines ferroelektrischen Aktuators mit angelegtem positivem externem elektrischem Feld gemäß dem Stand der Technik;
- Fig. 14c: eine schematische Darstellung eines ferroelektrischen Aktuators mit einem angelegten negativen externen elektrischen Feld gemäß dem Stand der Technik;
- Fig. 15a: eine schematische Darstellung eines ferroelektrischen Doppellagenaktuators ohne Auslenkung gemäß dem Stand der Technik;
- Fig. 15b: eine schematische Darstellung eines ferroelektrischen Doppellagenaktuators, der ausgelenkt ist gemäß dem Stand der Technik;
- Fig. 16: eine schematische Darstellung eines Mehrlagen-Aktuators, hergestellt mittels klassischen Ferroelektrika gemäß dem Stand der Technik;
- Fig. 17: eine schematische Darstellung eines Mehrlagen-Aktuators bei Verwendung von nicht ferroelektrischen Pyroelektrika gemäß dem Stand der Technik; und
- Fig. 18: eine schematische Darstellung einer Schichtabfolge eines ferroelektrischen Bimorphs gemäß dem Stand der Technik.

### Detaillierte Beschreibung der Ausführungsbeispiele gemäß den Figuren

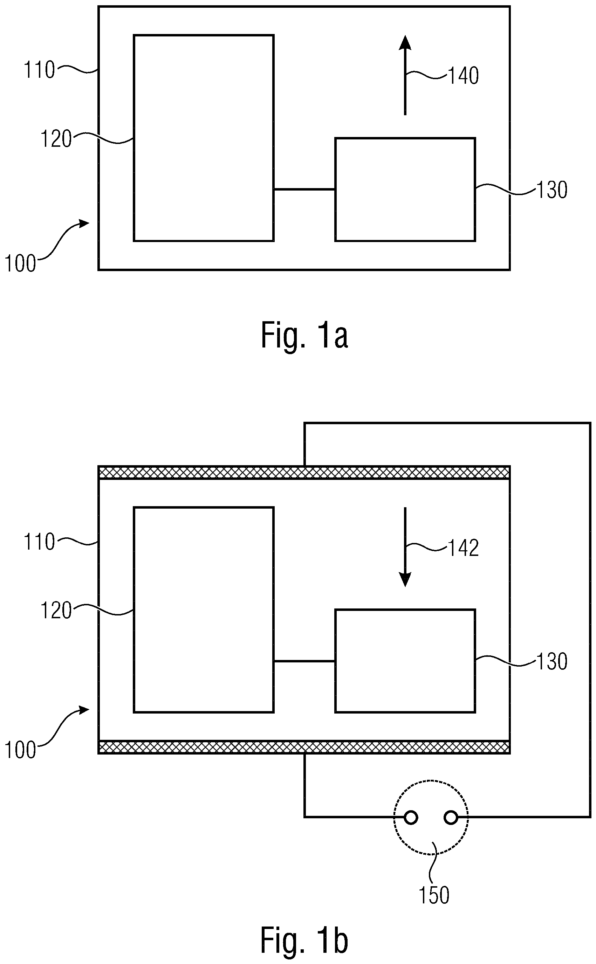

Fig. 1a zeigt eine schematische Darstellung eines ferroelektrischen Materials 100 mit einem Mischkristall 110 gemäß einem Ausführungsbeispiel der vorliegenden Erfindung. Der Mischkristall 110 umfasst AIN 120 und mindestens ein Nitrid eines Übergangsmetalls TMN 130. Das AIN 120 bildet mit dem Nitrid eines Übergangsmetalls TMN 130 eine chemische Verbindung AITMN. Fig. 1a ist nur eine schematische Skizze, auch wenn in der Fig. 1a das AIN 120 und das Nitrid eines Übergangsmetalls TMN 130 räumlich getrennt dargestellt sind ist dies in Wirklichkeit nicht der Fall. In dem Mischkristall 110 ist, zum Beispiel, die chemische Verbindung AITMN homogen verteilt. Der Anteil des Nitrids des Übergangsmetalls TMN 130 kann angepasst werden. Ein Verhältnis einer Anzahl an Übergangsmetall-Atomen TM des Nitrids des Übergangsmetalls TMN 130 zu einer Summe aus der Anzahl an Übergangsmetall-Atomen aus dem Nitrid des Übergangsmetalls TMN 130 und einer Anzahl an Aluminiumatomen des AIN 120 liegt zum Beispiel in einem Bereich ≥ 0,2 und ≤ 0,5, wobei das Verhältnis auch in einem Bereich ≥ 0,25 und ≤ 0,43, in einem Bereich ≥ 0,30 und ≤ 0,38 oder gemäß einem Ausführungsbeispiel in einem Bereich ≥ 0,32 und ≤ 0,36, wie z. B. bei 0,36, liegen kann. Somit kann die chemische Verbindung zwischen AIN 120 und dem Nitrid eines Übergangsmetalls TMN 130 als Al₁₋ₓTMₓN dargestellt werden, wobei x das Verhältnis einer Anzahl an Übergangsmetall-Atomen TM des Nitrids des Übergangsmetalls TMN 130 zu einer Summe aus der Anzahl an Übergangsmetall-Atomen aus dem Nitrid des Übergangsmetalls TMN 130 und einer Anzahl an Aluminiumatomen des AIN 120 ist. Ein Erhöhen des Anteils des Nitrids des Übergangsmetalls TMN 130 bewirkt beispielsweise, dass der Mischkristall 110 ferroelektrisch wird. Das Übergangsmetall TM des Nitrids des Übergangsmetalls TMN 130 kann beispielsweise Scandium SC, Yttrium Y, Titan Ti, Niob Nb oder Chrom Cr sein. Der Mischkristall 110 hat eine Polarität 140.

Für das ferroelektrische Material 100 lässt sich beispielsweise die intrinsische mechanische Spannung einstellen. Des Weiteren sind die dielektrischen Verluste des Mischkristalls 110 geringer als in klassischen Ferroelektrika wie PZT.

Das ferroelektrische Material kann, am Beispiel von Al₁₋ₓScₓN, bereits bei Abscheidetemperaturen von 400 °C hergestellt werden und ist damit, wie reines AIN, CMOS-kompatibel. Die hohe elektrische Spannungsfestigkeit von reinem AIN (> 400 V/µm) bleibt auch in Al₁₋ₓScₓN erhalten. Ebenso erhalten bleiben die niedrigen dielektrischen Verluste von in der Regel deutlich unter 1 % [12] und die Möglichkeit, die intrinsische mechanische Verspannung des ferroelektrischen Materials einzustellen [11]. Das ferroelektrische Material ist CMOS-kompatibel.

Fig. 1b zeigt das ferroelektrische Material 100 gemäß einem Ausführungsbeispiel der vorliegenden Erfindung gemäß dem ferroelektrischen Material 100 aus Fig. 1a. Das ferroelektrische Material 100 umfasst einen Mischkristall 110. Der Mischkristall 110 umfasst AIN 120 und mindestens ein Nitrid eines Übergangsmetalls 130. An das ferroelektrische Material 100 wird eine Umschaltspannung 150 angelegt, wodurch die Polarität 142 eingestellt wird. D. h., durch das Anlegen der Umschaltspannung 150 kann beispielsweise die ursprüngliche Polarität 140 (siehe Fig. 1a) so umgeschaltet werden, dass die neue Polarität 142 der alten Polarität 140 entgegengesetzt ist. Die Umschaltspannung 150 muss dafür unterhalb einer Durchbruchspannung des ferroelektrischen Materials 100 liegen. Wird an das ferroelektrische Material 100 eine geringere Spannung als die Umschaltspannung 140 angelegt, so ändert sich die Richtung der Polarität 140 nicht.

Die Existenz von ferroelektrischen Materialien basierend auf AIN 120 konnte, nach aktuellem Wissenstand, zuvor noch nie experimentell gezeigt werden. Experimentelle wissenschaftliche Veröffentlichungen und Patente zu Mischkristallen 110 aus AIN 120 und den Nitriden von Übergangsmetallen 130, wie etwa zu AlScN [13, 14], AIYN [15, 16], oder Al-TiN [17, 18] betreffen lediglich Materialeigenschaften wie piezoelektrische Koeffizienten und Elastizität in Abhängigkeit des Übergangsmetallanteils. Es wurde durch die jeweiligen Autoren kein Anzeichen für Ferroelektrizität veröffentlicht. Das ferroelektrische Material 100 wurde nun so verändert, durch eine Erhöhung des Anteils des Nitrids des Übergangsmetalls 130 und Anpassung der mechanischen Verspannung hin zu weniger Druckspannung oder mehr Zugspannung, so dass die Polarität 140 des ferroelektrischen Materials 100 durch Anlegen einer Umschaltspannung 140 umgeschaltet werden kann.

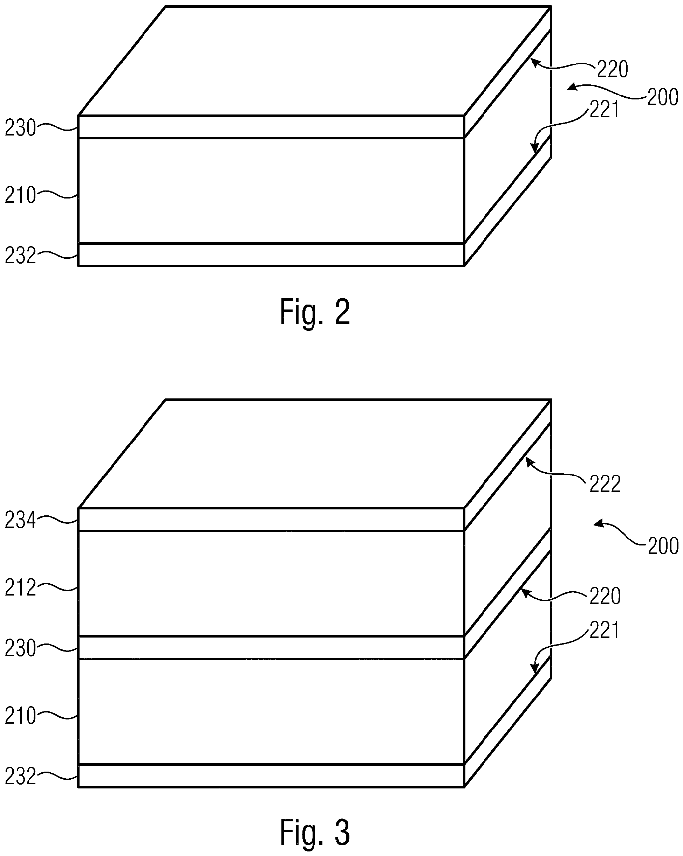

Fig. 2 zeigt ein MEMS-Bauteil 200 mit einer ersten ferroelektrischen Schicht 210, die das ferroelektrische Material umfasst gemäß einem Ausführungsbeispiel der vorliegenden Erfindung. Des Weiteren umfasst das MEMS-Bauteil eine erste Elektrode 230, die auf einer ersten Oberfläche 220 der ersten ferroelektrischen Schicht 210 angeordnet ist, und eine zweite Elektrode 232, die auf einer zweiten Oberfläche 221 der ersten ferroelektrischen Schicht 210 angeordnet ist. Die zweite Oberfläche 221 liegt der ersten Oberfläche 220 gegenüber. Die erste Elektrode 230 sowie die zweite Elektrode 232 bestehen beispielsweise aus elektrisch leitendem Material. Über die erste Elektrode 230 und die zweite Elektrode 232 kann eine Spannung an die ferroelektrische Schicht 210 angelegt werden. Ist die angelegte Spannung geringer als die Umschaltspannung so ändert sich die Richtung der Polarität der ferroelektrischen Schicht 210 nicht. Ist die Spannung jedoch so groß wie die benötige Umschaltspannung so kann die Polarität der ferroelektrischen Schicht 210 umgeschaltet werden. Wird dieses MEMS-Bauteil bei einer Spannung geringer als die Umschaltspannung betrieben, so ändert sich beispielsweise die Ausdehnung der ferroelektrischen Schicht 210 in eine der drei Raumrichtungen. Diese Umwandlung der zugeführten elektrischen Spannung in mechanische Bewegung kann mit diesem MEMS-Bauteil auf vielfältige Weise genutzt werden. Es ist allerdings auch möglich, dass eine umgekehrte Wandlung detektiert werden kann. So kann beispielsweise die Ausdehnung der ferroelektrischen Schicht 210 in mindestens eine Raumrichtung verändert werden und daraufhin über die erste Elektrode 230 gemeinsam mit der zweiten Elektrode 232 ein resultierendes elektrisches Signal gemessen werden.

Fig. 3 zeigt ein MEMS-Bauteil 200 mit einer ersten ferroelektrischen Schicht 210, einer zweiten ferroelektrischen Schicht 212, einer zwischen der ersten ferroelektrischen Schicht 210 und der zweiten ferroelektrischen Schicht 212 liegenden ersten Elektrode 230, eine zweite Elektrode 232, die an die zweite Oberfläche 221 der ersten ferroelektrischen Schicht 210 angebracht ist und eine dritte Elektrode 234, die an eine erste Oberfläche 222 der zweiten ferroelektrischen Schicht 212 angebracht ist gemäß einem Ausführungsbeispiel der vorliegenden Erfindung. Die erste Elektrode 230 ist auf der ersten Oberfläche 220 der ersten ferroelektrischen Schicht 210 angeordnet. Die zweite Oberfläche 221 der ersten ferroelektrischen Schicht 210 liegt der ersten Oberfläche 220 der ersten ferroelektrischen Schicht 210 gegenüber. Die zweite ferroelektrische Schicht 212, die auf der ersten Elektrode 230, gegenüber der ersten ferroelektrischen Schicht 210 angeordnet ist, umfasst das ferroelektrische Material. Die dritte Elektrode 234 ist auf der Oberfläche 222 der zweiten ferroelektrischen Schicht 212 angeordnet. Die erste Oberfläche 222 der zweiten ferroelektrischen Schicht 212 ist der ersten Elektrode 230 abgewandt angeordnet. Die erste ferroelektrische Schicht 210 umfasst ebenfalls das ferroelektrische Material.

Basierend auf dem erfindungsgemäßen ferroelektrischen Mischkristallen (ferroelektrisches Material) lassen sich damit möglichst einfach aufgebaute Mehrlagen-Aktuatoren (wie z. B. das MEMS-Bauteil 200) realisieren, ohne jedoch die spezifischen Nachteile klassischer Ferroelektrika in Kauf nehmen zu müssen. Ebenso ohne diese Nachteile umsetzen lassen sich möglichst einfache Konzepte für eine intrinsische Ladungsverstärkung. Diese ließen sich ebenfalls mit dem MEMS-Bauteil 200 realisieren. Das Material sowie seine Integration, und damit das MEMS-Bauteil, sind CMOS-kompatibel, da das ferroelektrische Material bei Temperaturen unter 500°C abgeschieden werden kann. Die ferroelektrischen Schichten der Multilage können mit einem einzigen Prozess abgeschieden werden, da man nicht auf eine in situ Manipulation der Polarisationsrichtung angewiesen ist, sondern die Polarisation der einzelnen Schichten noch nach der Herstellung, durch Anlegen einer Umschaltspannung, geändert werden kann. Zusätzliche Schichten, die eine bestimmte Polarisationsrichtung während des Abscheideprozesses einstellen, sind somit nicht erforderlich. Die Anzahl der notwendigen Isolationslagen und Elektrodenschichten wird minimiert, da die Polarisationsumkehr der einzelnen ferroelektrischen Schichten (z. B. der ersten ferroelektrische Schicht 210 und der zweiten ferroelektrischen Schicht 212) reversibel und kontrollierbar ist.

Das ferroelektrische Material ist genauso wie AIN einfach in MEMS-Prozess-Flows integrierbar (es kann z.B. keine Prozesserneuerung notwendig sein), aber das Anwendungsspektrum wird durch die ferroelektrische Eigenschaft des ferroelektrischen Materials massiv erweitert. Ferroelektrische aktuierte MEMS-Bauteile wie beispielsweise Lautsprecher, Ultraschallwandler, Schalter oder Spiegel würden von einer gegenüber dem Stand der Technik gesteigerten Arbeitsleistung profitieren. Insbesondere, wenn diese mit CMOS-Strukturen integriert werden sollen. Gleiches gilt für Sensorsysteme wie Mikrofone oder Accelerometer, welche Vorteile aus einer intrinsischen Ladungsverstärkung ziehen können sowie für Mikrogeneratoren.

Bei der Herstellung des MEMS-Bauteils 200 haben beispielsweise die erste ferroelektrische Schicht 210 und die zweite ferroelektrische Schicht 212 dieselbe Polarität. Dabei sollte die Polarität beispielsweise senkrecht zur zweiten Oberfläche 221 der ersten ferroelektrischen Schicht angeordnet sein. Wird nun an die erste Elektrode 230 und an die zweite Elektrode 232 eine Umschaltspannung an die erste ferroelektrische Schicht 210 angelegt, so wird die Polarität der ersten ferroelektrischen Schicht 210 umgeschaltet. Somit zeigt die Polarität der ersten ferroelektrischen Schicht 210 in entgegengesetzte Richtung als die Polarität der zweiten ferroelektrischen Schicht 212. Wird das MEMS-Bauteil 200 beispielsweise mit derselben Spannung betrieben (die zweite Elektrode 232 und die dritte Elektrode 234 haben beispielsweise das gleiche Spannungsniveau und die erste Elektrode 230 hat das gleiche Spannungsniveau mit umgekehrten Vorzeichen). So zeigen die elektrischen Felder (ein erstes elektrisches Feld, das die erste ferroelektrische Schicht 210 durchdringt und ein zweites elektrisches Feld, das die zweite ferroelektrische Schicht 212 durchdringt) in entgegengesetzte Richtungen. Da die Polarität sowie die Richtung des elektrischen Feldes angelegt an die jeweilige ferroelektrische Schicht (erste ferroelektrische Schicht 210 und zweite ferroelektrische Schicht 212) in entgegengesetzte Richtungen, bezüglich der jeweils anderen ferroelektrischen Schicht, weisen, haben beide ferroelektrische Schichten die gleiche Kraftantwort auf das elektrische Signal. So zeigt Beispielsweise sowohl die Polarität als auch die Richtung des elektrischen Feldes der ersten ferroelektrischen Schicht in eine selbe erste Richtung und die Polarität als auch die Richtung des elektrischen Feldes der zweiten ferroelektrischen Schicht zeigen in eine selbe zweite Richtung, wobei die erste Richtung der zweiten Richtung entgegengesetzt ist. Somit erhöht sich die Kraft des MEMS-Bauteils 200. Weiter kann bei einer hohen Umschaltspannung an der ferroelektrischen Schicht (zum Beispiel, an der ersten ferroelektrischen Schicht 210 und/oder an der zweiten ferroelektrischen Schicht 212), welche aus dem ferroelektrischen Material besteht, das MEMS Bauteil 200 mit hohen bipolaren Spannungen betrieben werden, also Spannungen, welche zu einem Zeitpunkt positiv und zu einem anderen Zeitpunkt negativ sind.

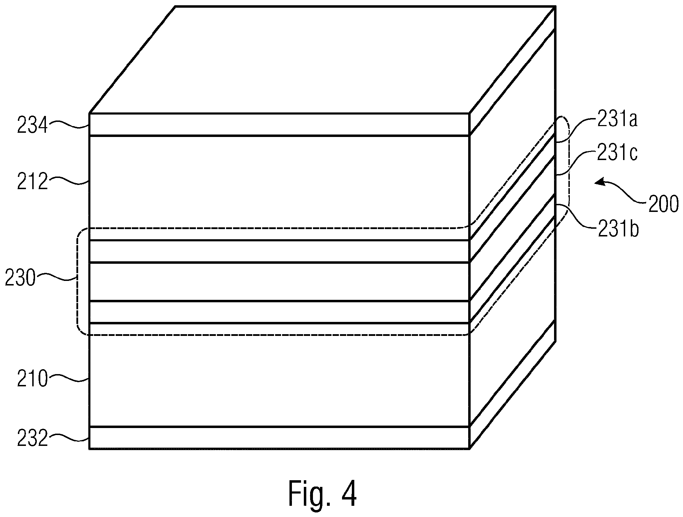

Fig. 4 zeigt ein MEMS-Bauteil 200 mit einer ersten ferroelektrischen Schicht 210, einer zweiten ferroelektrischen Schicht 212, einer ersten Elektrode 230, einer zweiten Elektrode 232 und einer dritten Elektrode 234 gemäß einem Ausführungsbeispiel der vorliegenden Erfindung. Die erste Elektrode 230 des MEMS-Bauteils 200 weist eine erste Elektrodenschicht 231a und eine zweite Elektrodenschicht 231b auf. Die erste Elektrodenschicht 231a berührt beispielsweise die zweite ferroelektrische Schicht 212 und die zweite Elektrodenschicht 231b berührt z. B. die erste ferroelektrische Schicht 210. Die erste Elektrodenschicht 231a ist von der zweiten Elektrodenschicht 231b durch eine dazwischenliegende Schicht 231c getrennt. In der Schicht 231c liegt eine neutrale Ebene, die das MEMS-Bauteil 200 teilt, beispielsweise mittig. Somit befindet sich auf einer Seite der neutralen Ebene die erste Elektrodenschicht 231a, die zweite ferroelektrische Schicht 212 und die dritte Elektrode 234. Auf der anderen Seite der neutralen Ebene befindet sich somit die zweite Elektrodenschicht 231b, die erste ferroelektrische Schicht 210 und die zweite Elektrode 232. Die Schicht 231c kann beispielsweise eine Isolationsschicht oder eine passive Schicht sein. Durch die Schicht 231c wird ermöglicht, dass die erste ferroelektrische Schicht 210 unabhängig von der zweiten ferroelektrischen Schicht 212 genutzt werden kann. Die Schicht 231c kann zudem als Trägermaterial für die Elektroden und die ferroelektrischen Schichten bei deren Abscheidung dienen.

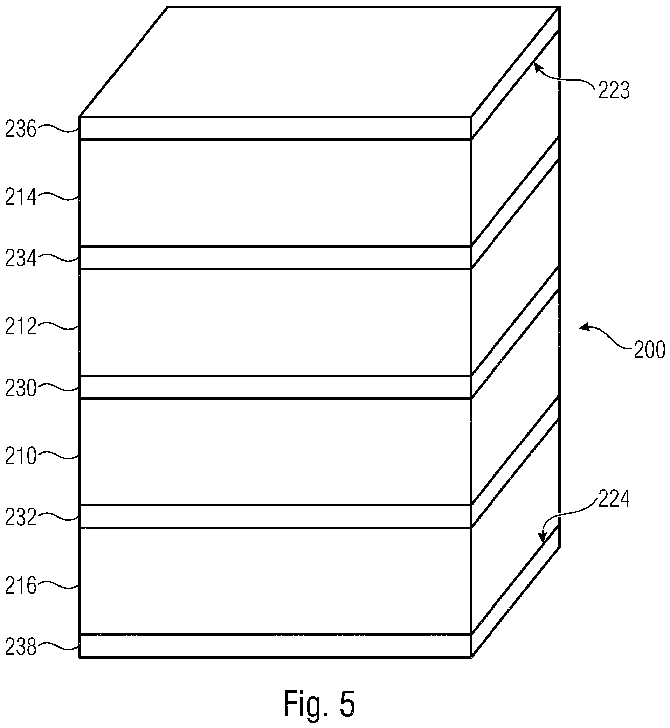

Fig. 5 zeigt ein MEMS-Bauteil 200 mit einer ersten ferroelektrischen Schicht 210, einer zweiten ferroelektrischen Schicht 212, einer ersten Elektrode 230, einer zweiten Elektrode 232 und einer dritten Elektrode 234 gemäß einem Ausführungsbeispiel der vorliegenden Erfindung, wie das MEMS-Bauteil 200 aus Fig. 3. Zusätzlich hat das MEMS-Bauteil 200 aus Fig. 5 eine dritte ferroelektrische Schicht 214, die auf der dritten Elektrode 234, gegenüber der zweiten ferroelektrischen Schicht 212 angeordnet ist, eine vierte Elektrode 236, die auf einer ersten Oberfläche 223 der dritten ferroelektrischen Schicht 214 angeordnet ist, eine vierte ferroelektrische Schicht 216, die auf der zweiten Elektrode 232, gegenüber der ersten ferroelektrischen Schicht 210, angeordnet ist, und eine fünfte Elektrode 238, die auf einer ersten Oberfläche 224 der vierten ferroelektrischen Schicht 216 angeordnet ist. Die erste Oberfläche 223 der dritten ferroelektrischen Schicht 214 ist der dritten Elektrode 234 abgewandt angeordnet. Die erste Oberfläche 224 der vierten ferroelektrischen Schicht 216 ist der zweiten Elektrode 232 abgewandt angeordnet. Das MEMS-Bauteil 200 hat vier ferroelektrische Schichten (die erste ferroelektrische Schicht 210, die zweite ferroelektrische Schicht 212, die dritte ferroelektrische Schicht 214 und die vierte ferroelektrische Schicht 216), wodurch es ein Mehrlagen-MEMS-Bauteil bildet. Je mehr ferroelektrische Schichten ein MEMS-Bauteil 200 aufweist, desto größer ist die Kraft des MEMS-Bauteils 200 oder die intrinsische Ladungsverstärkung.

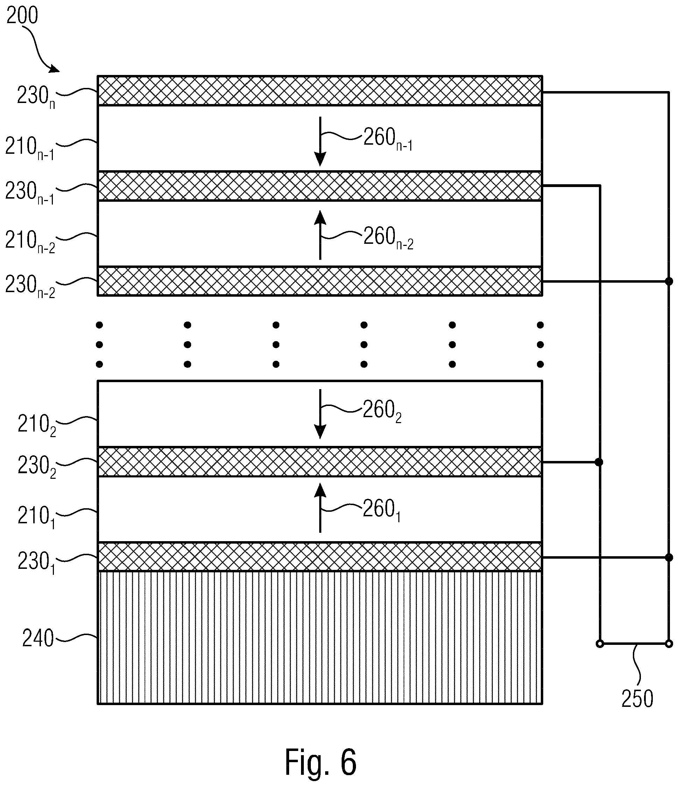

Fig. 6 zeigt ein MEMS-Bauteil 200 mit Elektroden 230₁ bis 230ₙ, ferroelektrischen Schichten 210₁ bis 210ₙ₋₁, ein Substrat 240 und eine Spannungsversorgung 250 gemäß einem Ausführungsbeispiel der vorliegenden Erfindung. Der Index n ist hierbei eine natürliche Zahl größer oder gleich 2 (beispielsweise, n≥10, n≥100 oder n≥1000, wie z. B n=1253). Das Substrat 240 ist an eine erste Elektrode 230₁ angeordnet. Die Spannungsversorgung 250 ist an die Elektroden 230₁ bis 230, angeschlossen. Jede ferroelektrische Schicht 210₁ bis 210ₙ₋₁ weist eine Polarität 260₁ bis 260ₙ₋₁ auf. Die Spannungsquelle 250 ist über die Elektroden 230₁ bis 230ₙ so an die ferroelektrischen Schichten 210₁ bis 210ₙ₋₁ angeschlossen, dass die Richtung des elektrischen Feldes (das die einzelnen ferroelektrischen Schichten 210₁ bis 210ₙ₋₁ durchdringt und für jede ferroelektrische Schicht 210₁ bis 210ₙ₋₁ eine andere Richtung aufweisen kann) entweder parallel und in gleicher Richtung zeigend zu der jeweiligen Polarisation 260₁ bis 260ₙ₋₁ jeder ferroelektrischen Schicht 210₁ bis 210ₙ₋₁ gerichtet ist oder parallel und in entgegengesetzte Richtung zu der jeweiligen Polarisation 260₁ bis 260ₙ₋₁ der jeweiligen ferroelektrischen Schichten 210₁ bis 210ₙ₋₁ ausgerichtet ist. Somit ist in jeder ferroelektrischen Schicht 210₁ bis 210ₙ₋₁ beispielsweise die Richtung der Polarität 260₁ bis 260ₙ₋₁ gleichgerichtet zu der Richtung des elektrischen Feldes, das von der Spannungsquelle 250 bereitgestellt wird, oder die Polarisationsrichtung 260₁ bis 260ₙ₋₁ ist in jeder ferroelektrischen Schicht 210₁ bis 210ₙ₋₁ entgegengerichtet zu der Richtung des elektrischen Feldes, das von der Spannungsversorgung 250 bereitgestellt wird. Somit haben alle ferroelektrischen Schichten 210₁ bis 210ₙ₋₁ die gleiche Kraftwirkung und die Kraft des MEMS-Bauteils 200 ist somit stärker als mit weniger Schichten (wie z. B. mit n/8 Schichten, n/4 Schichten oder sogar n/2 Schichten).

Während des Betriebs des MEMS-Bauteils 200 ist die Spannung bereitgestellt durch die Spannungsversorgung 250 geringer als die Umschaltspannung. Somit wird im Betrieb des MEMS-Bauteils 200 die Richtung der Polarität 260₁ bis 260ₙ₋₁ jeder ferroelektrischen Schicht 210₁ bis 210ₙ₋₁ nicht verändert. Falls die Polarität 260₁ bis 260ₙ₋₁ einer oder mehrerer ferroelektrischer Schichten 210₁ bis 210ₙ₋₁ umgeschaltet werden soll, kann die Spannungsversorgung 250 eine Umschaltspannung bereitstellen. Hierfür müssen mindestens zwei Elektroden, die eine ferroelektrische Schicht zwischen sich einschließen, mit der Umschaltspannung versorgt werden. So kann z. B. an die Elektrode 230₁ und die Elektrode 230₂ die Umschaltspannung angelegt werden, wodurch die Polarität 260₁ der ferroelektrischen Schicht 210₁ umgekehrt wird und somit in entgegengesetzte Richtung zur voran eingestellten Polarität 260₁ zeigt. Je nach Anwendungsgebiet kann somit die Polarität 260₁ bis 260ₙ₋₁ reversibel und kontrollierbar eingestellt werden.

Es besteht die Möglichkeit mittels polarisationsinvertierten Multilagen eine Ladungsverstärkung in Sensor- und Mikrogeneratoranwendungen zu realisieren. Es lassen sich basierend auf dem ferroelektrischen Material möglichst einfache Multilagen-Aktuatoren aufbauen. Das ferroelektrische Material, das für jede ferroelektrische Schicht 210₁ bis 210ₙ₋₁ verwendet wird, weist eine hohe elektrische Durchbruchfeldstärke auf, wodurch große Kräfte erzeugt werden können.

Die ferroelektrischen Schichten der Multilage können mit einem einzigen Prozess abgeschieden werden, da man nicht auf eine in situ Manipulation der Polarisationsrichtung angewiesen ist. Zusätzliche Schichten oder die Hinzugabe weiterer chemischer Elemente, die eine bestimmte Polarisationsrichtung während des Abscheideprozesses einstellen, sind nicht erforderlich. Die Anzahl der notwendigen Isolationslagen und Elektrodenschichten wird minimiert.

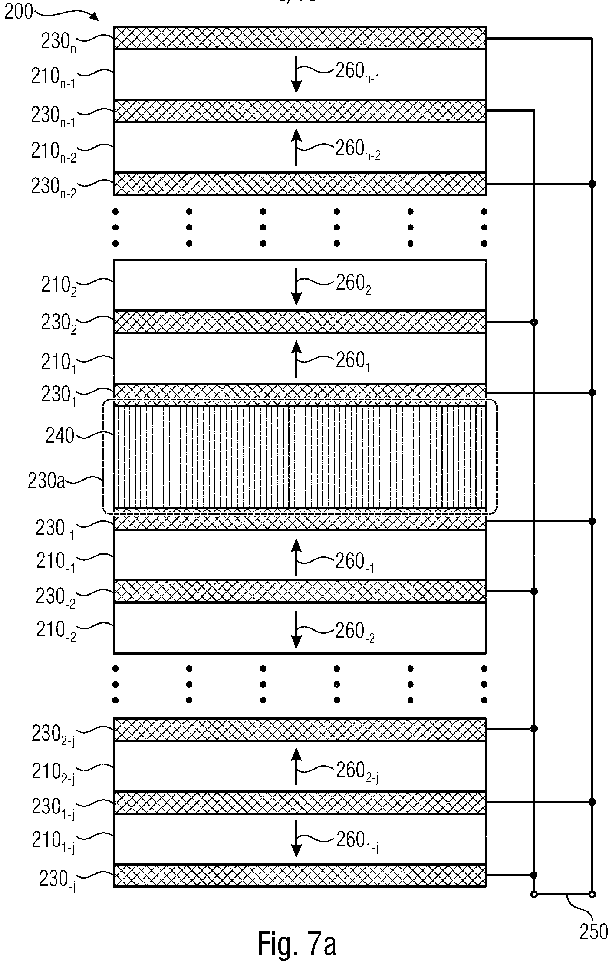

Fig. 7a zeigt ein MEMS-Bauteil 200 mit Elektroden 230₋ⱼ bis 230ₙ, ferroelektrischen Schichten 210₁₋ⱼ bis 210ₙ₋₁, ein Substrat 240 und eine Spannungsversorgung 250 gemäß einem Ausführungsbeispiel der vorliegenden Erfindung. Der Index n und j kann dabei eine beliebige natürliche Zahl ≥ 2 sein. Jede ferroelektrische Schicht 210₁₋ⱼ bis 210ₙ₋₁ weist eine Polarität 260₁₋ⱼ bis 260ₙ₋₁ auf. In dem Substrat 240 liegt eine neutrale Ebene. Die neutrale Ebene kann beispielsweise das MEMS-Bauteil 200 mittig teilen, das bedeutet, dass gleich viele identische Schichten auf beiden Seiten der neutralen Ebene aufzufinden sind (z. B. wenn n=j). Nur weil in diesem Ausführungsbeispiel auf beiden Seiten des Substrats 240 gleich viele ferroelektrische Schichten 210₁₋ⱼ bis 210ₙ₋₁ dargestellt sind, heißt das nicht, dass dies eine notwendige Bedingung für die Funktion des MEMS-Bauteils ist. Es ist ebenso möglich, dass auf einer Seite des Substrats 240 mehr ferroelektrische Schichten als auf der anderen Seite des Substrats (auf der gegenüberliegenden Seite) aufzufinden sind (z. B. n>j oder n<j). Als Extrembeispiel ist das MEMS-Bauteil 200 aus Fig. 6 zu sehen, bei dem auf einer Seite des Substrats 240 keine ferroelektrischen Schichten aber auf der anderen Seite des Substrats 240 eine beliebige Anzahl an ferroelektrischen Schichten 210₁ bis 210ₙ₋₁ aufzufinden ist.

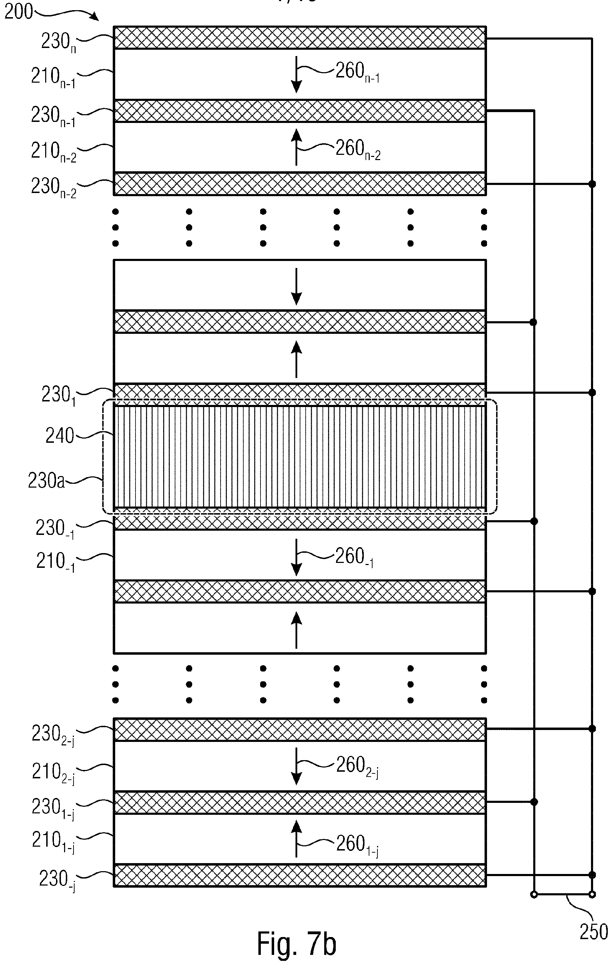

Das MEMS-Bauteil 200 in Fig. 7b weist dieselben Komponenten wie das MEMS-Bauteil 200 aus Fig. 7A auf, nur die Polarität 260₁₋ⱼ bis 260₋₁ der ferroelektrischen Schichten 210₁₋ⱼ bis 210₋₁ zeigt in eine entgegengesetzte Richtung und die Spannungsversorgung 250 ist auf andere Weise an die Elektroden 230₋ⱼ bis 230, angeschlossen, gemäß einem Ausführungsbeispiel der vorliegenden Erfindung. Das Substrat 240 kann beispielsweise eine passive Schicht oder eine Isolationsschicht darstellen. In Fig. 7a ist es z. B. egal, ob das Substrat 240 eine Isolationsschicht ist oder eine passive Schicht, da die beiden Elektroden 230₋₁ und 230₁ an das gleiche Spannungsniveau der Spannungsversorgung 250 angeschlossen sind. Somit kann das Substrat 240 z. B. auch aus elektrisch leitendem Material bestehen. Hingegen bei dem MEMS-Bauteil 200 aus Fig. 7b sind die Elektroden 230₋₁ und 230₁ an unterschiedliche Spannungsniveaus der Spannungsversorgung 250 angeschlossen, wodurch das Substrat 240 z. B. eine Isolationsschicht sein muss, damit kein Kurzschluss zwischen den Elektroden 230₋₁ und 230₁ hervorgerufen wird.

Da sich zwischen dem MEMS-Bauteil 200 aus Fig. 7a und dem MEMS-Bauteil 200 aus Fig. 7b sowohl die Richtung der Polarität 260₁₋ⱼ bis 260₋₁ als auch die Anschlüsse der Elektroden 230₋ⱼ bis 230₋₁ an die Spannungsversorgung 250 umgekehrt haben, haben das MEMS-Bauteil 200 aus Fig 7a und das MEMS-Bauteil 200 aus Fig. 7b dieselbe Funktionsweise. Bei den beiden Ausführungsformen des MEMS-Bauteils 200 aus Fig. 7a und des MEMS-Bauteils 200 aus Fig. 7b sind die Kräfte auf der einen Seite des Substrats 240 entgegengesetzt zu den Kräften auf der anderen Seite des Substrats 240 gerichtet. So kann es z. B. passieren, dass sich die ferroelektrischen Schichten 210₁ bis 210ₙ₋₁ in einer Raumrichtung verkleinern und die ferroelektrischen Schichten 210₋₁ bis 210₁₋ⱼ in der gleichen Raumrichtung vergrößern, wodurch es zu einem Biegen des MEMS-Bauteils 200 kommt. Es sind darüber hinaus laterale Aktuatoren denkbar, bei denen die Kräfte von der einen Seite der neutralen Ebene gegenüber der anderen Seite der neutralen Ebene (von einer Seite des Substrats 240 zu der anderen Seite des Substrats 240) liegenden Schichtsysteme (die jeweiligen ferroelektrischen Schichten 210₁₋ⱼ bis 210ₙ₋₁ und die Elektroden 230₋ⱼ bis 230ₙ) gleichgerichtet sind.

In anderen Worten stellt das MEMS-Bauteil 200 aus Fig. 7a und das MEMS-Bauteil 200 aus Fig. 7b Ausführungen mit beidseitig aktiv beschichteter passiver Schicht (Substrat 240) dar. Gezeigt sind zwei Realisierungen der elektrischen Kontaktierung, wobei das MEMS-Bauteil 200 aus Fig. 7a keine Ansprüche an die Isolator Eigenschaften der passiven Schicht (des Substrats 240) stellt.

Des Weiteren kann die Elektrode 230₁ als eine erste Elektrodenschicht und die Elektrode 230₋₁ als eine zweite Elektrodenschicht der Elektrode 230a angesehen werden. Zwischen der ersten Elektrodenschicht und der zweiten Elektrodenschicht befindet sich eine weitere Schicht (Substrat 240), wobei diese Schicht z. B. eine passive Schicht oder eine Isolationsschicht sein kann.

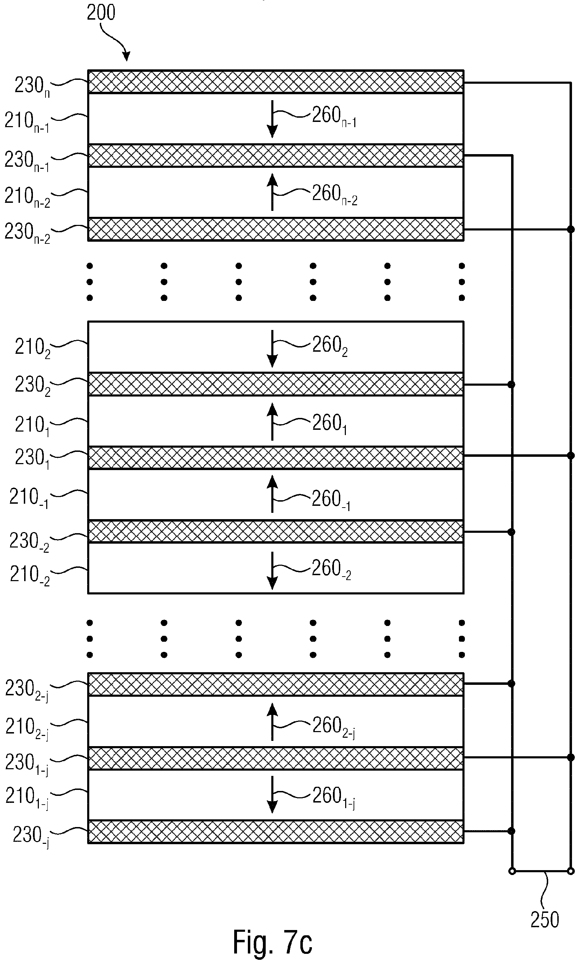

In Fig. 7c ist ein MEMS-Bauteil 200 mit ferroelektrischen Schichten 210₁₋ⱼ bis 210ₙ₋₁, Elektroden 230₋ⱼ bis 230ₙ und einer Spannungsversorgung 250 gemäß einem Ausführungsbeispiel der vorliegenden Erfindung dargestellt. Jede ferroelektrische Schicht 210₁₋ⱼ bis 210ₙ₋₁ weist eine Polarität 260₁₋ⱼ bis 260ₙ₋₁ auf. Die Elektrode 230₁ umfasst eine neutrale Ebene, die das MEMS-Bauteil 200 in ein erstes Mehrlagenschichtsystem (alle ferroelektrischen Schichten 210₁ bis 210ₙ₋₁) und ein zweites Mehrlagenschichtsystem (bestehend aus den ferroelektrischen Schichten 210₋₁ bis 210₁₋ⱼ) aufteilt. Wird eine Spannung geringer als die Umschaltspannung an die Spannungsversorgung 150 angelegt, so dehnen sich im Falle dieses Beispiels beispielsweise die ferroelektrischen Schichten 210₁ bis 210ₙ₋₁ aus und die ferroelektrischen Schichten 210₋₁ bis 210₁₋ⱼ (auf der anderen Seite der neutralen Ebene) ziehen sich zusammen. Durch diesen Mechanismus kommt es zu einer Verbiegung des MEMS-Bauteils 200. Je mehr ferroelektrische Schichten das MEMS-Bauteil 200 aufweist, desto größer ist die biegende Kraft im MEMS-Bauteil 200 bei Anlegen einer Spannung an die Elektroden 230₋ⱼ bis 230ₙ durch die Spannungsversorgung 250.

In anderen Worten stellt das MEMS-Bauteil 200 aus Fig. 7c eine Ausführung eines MEMS-Bauteils 200 ohne passive Schicht dar. Die ferroelektrischen Schichten 210₁ bis 210ₙ₋₁ oberhalb der neutralen Ebene (der Elektrode 230₁) dehnen sich beispielsweise gegensinnig zu darunterliegenden (ferroelektrischen Schichten 210₋₁ bis 210₁₋ⱼ).

Hinsichtlich der Rolle einer passiven Schicht (diese kann auch das Substrat selber sein) sind drei generelle Ausführungen denkbar: eine einseitig aktiv beschichtete passive Schicht (siehe das MEMS-Bauteil 200 aus Fig. 6), eine beidseitig beschichtete passive Schicht (siehe das MEMS-Bauteil 200 aus Fig. 7a und das MEMS-Bauteil 200 aus Fig. 7b) sowie ein rein aktives Mehrlagensystem ohne passive Schicht (siehe das MEMS-Bauteil 200 aus Fig. 7c). Sämtliche Ausführungsbeispiele ließen sich generell auch mit einer inversen Materialpolarisation realisieren. AITMN steht dabei für einen ferroelektrischen Mischkristall basierend auf AIN und dem Nitrid von Übergangsmetallen (TM), welcher Grundlage für die Einstellung der Materialpolarisation ist. Mindestens eine der der hier als ferroelektrisch bezeichneten Schichten des MEMS-Bauteils 200 (aus Fig. 3, Fig. 4, Fig. 5, Fig. 6, Fig. 3, Fig. 7a, Fig. 7b und Fig. 7c) weist das ferroelektrische Material auf. Einzelne der hier als ferroelektrisch bezeichneten Schichten können jedoch auch rein piezoelektrisch sein, da sie z.B. nicht das ferroelektrische Material enthalten. So lange eine Mindestanzahl an ferroelektrischen Schichten, welche das ferroelektrische Material enthalten, vorhanden ist (z.B. jede zweite Schicht) kann es sein, dass sich die Funktion des Bauteils 200 nicht ändert. Die Ausführungsbeispiele sind sowohl für Aktuation als auch für intrinsische Ladungsverstärkung relevant (in letzterem Fall, zum Beispiel, ohne die Spannungsversorgung 250).

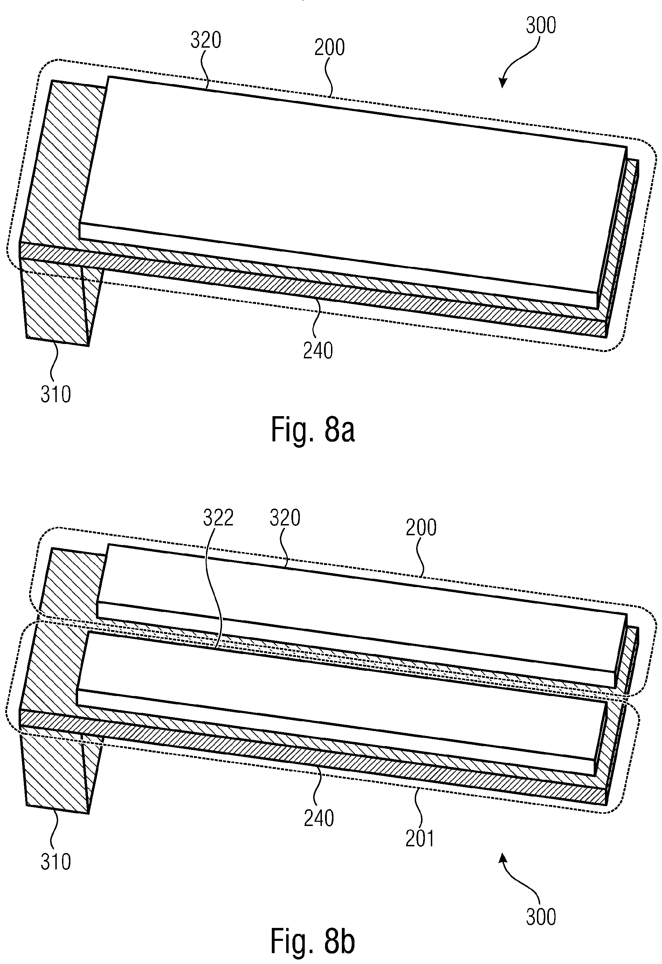

Fig. 8a zeigt eine schematische Darstellung einer MEMS-Vorrichtung 300 mit einem Substrat 310 und einem ersten MEMS-Bauteil 200 gemäß einem Ausführungsbeispiel der vorliegenden Erfindung. Das MEMS-Bauteil 200 weist eine passive Schicht 240 und ferroelektrische Multilagen 320 auf. Die passive Schicht 240 des MEMS-Bauteils 200 ist beispielsweise an dem Substrat 310 auslenkbar angeordnet. Wie in Fig. 8a dargestellt, kann die passive Schicht 240 einseitig an das Substrat 310 angeordnet sein. Die Fläche, mit der die passive Schicht 240 das Substrat 310 berührt, befindet sich beispielsweise gegenüber der Fläche, mit der die passive Schicht 240 an die ferroelektrischen Mehrlagen 320 angeordnet ist. Es ist aber auch möglich, dass die ferroelektrischen Mehrlagen 320 auf der gleichen Fläche, mit der die passive Schicht 240 das Substrat 310 berührt, angeordnet sind, oder auf beiden Flächen der die passive Schicht 240 (die Fläche, mit der die passive Schicht 240 das Substrat 310 berührt und die ihr gegenüberliegende) angeordnet sind.

Die MEMS-Vorrichtung 300 aus Fig. 8a ist ein Ausführungsbeispiel eines vertikalen Biegeaktuators.

Fig. 8b zeigt eine MEMS-Vorrichtung 300 mit einem ersten MEMS-Bauteil 200 und einem zweiten MEMS-Bauteil 201 gemäß einem Ausführungsbeispiel der vorliegenden Erfindung. Das erste MEMS-Bauteil 200 weist eine erste passive Schicht auf und das zweite MEMS-Bauteil 201 weist eine zweite passive Schicht auf, wobei die erste passive Schicht und die zweite passive Schicht eine Gemeinschaft sind und als passive Schicht 240 gekennzeichnet sind. Das erste MEMS-Bauteil 200 und das zweite MEMS-Bauteil 201 können beispielsweise die gleiche Ausführungsform und Funktion aufweisen. Eine erste ferroelektrische Multilage 320 des ersten MEMS-Bauteils 200 ist parallel zu einer zweiten ferroelektrischen Multilage 322 des zweiten MEMS-Bauteils 201 angeordnet. In anderen Worten, die ferroelektrischen Schichten (die erste ferroelektrische Multilage 320 und die zweite ferroelektrische Multilage 322) des ersten MEMS-Bauteils 200 und des zweiten MEMS-Bauteils 201 sind parallel angeordnet. Die passive Schicht 240 ist auslenkbar an das Substrat 310 angeordnet. Die MEMS-Vorrichtung 300 aus Fig. 8b ist ein Ausführungsbeispiel eines lateralen oder torsionalen Aktuators (die beiden Multilagen (die erste ferroelektrische Multilage 320 und die zweite ferroelektrische Multilage 322) werden beispielsweise gegenphasig angeregt).

Die ferroelektrische Multilage 320 aus Fig. 8a sowie die ferroelektrische Multilage 320 und 322 aus Fig. 8b umfassen das ferroelektrische Material.

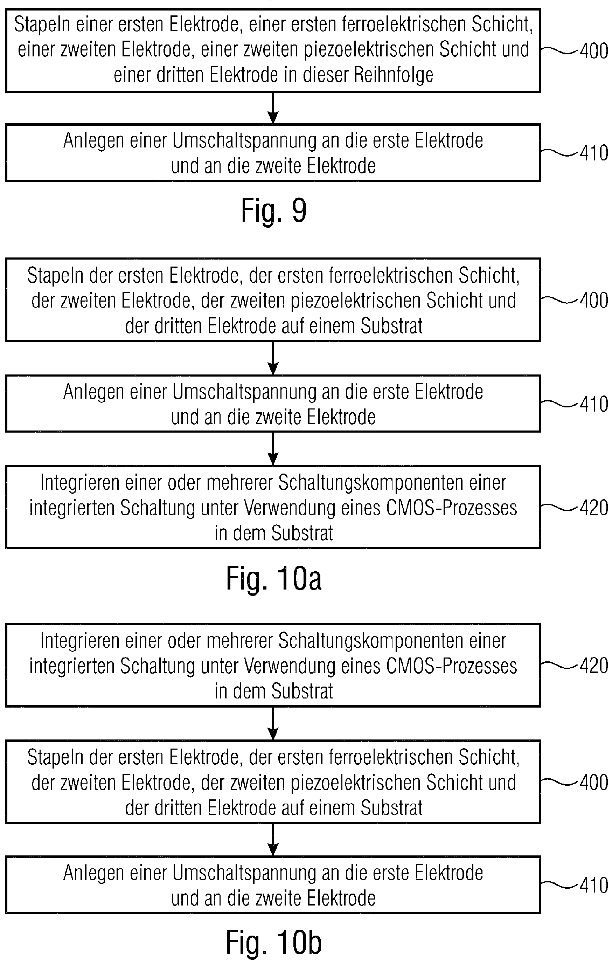

Fig. 9 zeigt ein Blockdiagramm eines Verfahrens zur Herstellung eines MEMS-Bauteils gemäß einem Ausführungsbeispiel der vorliegenden Erfindung. In einem Schritt des Verfahrens werden, zum Beispiel, eine erste Elektrode, eine erste ferroelektrische Schicht, eine zweite Elektrode, eine zweite piezoelektrische Schicht und eine dritte Elektrode in dieser Reihenfolge gestapelt 400. Durch diesen Schritt entsteht beispielsweise ein MEMS-Bauteil wie das MEMS-Bauteil 200 aus Fig. 3 oder das MEMS-Bauteil 200 aus Fig. 4. Die erste ferroelektrische Schicht und die zweite piezoelektrische Schicht weisen, zum Beispiel, die gleiche Polarisationsrichtung auf und die erste ferroelektrische Schicht weist ein ferroelektrisches Material auf. Das ferroelektrische Material umfasst einen Mischkristall, der AIN und mindestens ein Nitrid eines Übergangsmetalls umfasst. Der Anteil des Nitrids des Übergangsmetalls ist, zum Beispiel, so gewählt, dass eine Richtung einer Polarität des ferroelektrischen Materials durch Anlegen einer Umschaltspannung umschaltbar ist. Die Umschaltspannung liegt unterhalb einer Durchbruchspannung des ferroelektrischen Materials. Das Verfahren weist ferner folgenden Schritt auf: Anlegen 410 einer Umschaltspannung an die erste Elektrode und an die zweite Elektrode, wobei die Polarisationsrichtung der ersten ferroelektrischen Schicht umgekehrt wird, so dass die Polarisationsrichtung der ersten ferroelektrischen Schicht umgekehrt wird (zum Beispiel, entgegengesetzt der Polarisationsrichtung der zweiten piezoelektrischen Schicht).

Fig. 10a zeigt ein Blockdiagramm eines Verfahrens zur Herstellung eines MEMS-Bauteils, verbunden mit einem Substrat mit einer integrierten Schaltung unter Verwendung eines CMOS-Prozesses, gemäß einem Ausführungsbeispiel der vorliegenden Erfindung. Das Verfahren umfasst in einem ersten Schritt ein Stapeln 400 der ersten Elektrode, der ersten ferroelektrischen Schicht, der zweiten Elektrode, der zweiten piezoelektrische Schicht und der dritten Elektrode auf einem Substrat. Ein zweiter Schritt des Verfahrens umfasst ein Anlegen 410 einer Umschaltspannung an die erste Elektrode und an die zweite Elektrode, wobei die Polarisationsrichtung der ersten ferroelektrischen Schicht umgekehrt wird, so dass die Polarisationsrichtung der ersten ferroelektrischen Schicht umgekehrt wird. In einem weiteren Schritt des Verfahrens wird eine oder mehrere Schaltungskomponenten einer integrierten Schaltung unter Verwendung eines CMOS-Prozesses in dem Substrat integriert 420. Der Schritt Stapeln 400 und Anlegen 410 sind analog zu den Schritten Stapeln 400 und Anlegen 410 aus dem Verfahren dargestellt in Fig. 9.

Fig. 10b zeigt ein Blockdiagramm eines Verfahrens zur Herstellung eines MEMS-Bauteils, verbunden mit einem Substrat mit einer integrierten Schaltung unter Verwendung eines CMOS-Prozesses, gemäß einem Ausführungsbeispiel der vorliegenden Erfindung. Das Verfahren umfasst in einem ersten Schritt ein Integrieren 420 einer oder mehrerer Schaltungskomponenten einer integrierten Schaltung unter Verwendung eines CMOS-Prozesses in dem Substrat. Ein zweiter Schritt des Verfahrens umfasst ein Stapeln 400 der ersten Elektrode, der ersten ferroelektrischen Schicht, der zweiten Elektrode, der zweiten piezoelektrische Schicht und der dritten Elektrode auf einem Substrat. In einem weiteren Schritt des Verfahrens wird eine Umschaltspannung an die erste Elektrode und an die zweite Elektrode angelegt 410, wobei die Polarisationsrichtung der ersten ferroelektrischen Schicht umgekehrt wird, so dass die Polarisationsrichtung der ersten ferroelektrischen Schicht umgekehrt wird. Der Schritt Stapeln 400 und Anlegen 410 sind anaolg zu den Schritten Stapeln 400 und Anlegen 410 aus dem Verfahren dargestellt in Fig. 9.

Das MEMS-Bauteil in Fig. 10a sowie in Fig. 10b, bestehend aus der ersten Elektrode, der ersten ferroelektrischen Schicht, der zweiten Elektrode, der zweiten piezoelektrische Schicht und der dritten Elektrode, ist beispielsweise das MEMS-Bauteil 200 aus Fig. 3 oder das MEMS-Bauteil 200 aus Fig. 4. Es ist auch möglich, dass mehr als drei Elektrodenschichten und zwei ferroelektrische Schichten mittels dieses Verfahrens gestapelt werden, wodurch beispielsweise das MEMS-Bauteil 200 aus Fig. 5, das MEMS-Bauteil 200 aus Fig. 6, das MEMS-Bauteil 200 aus Fig. 7a, das MEMS-Bauteil 200 aus Fig. 7b, das MEMS-Bauteil 200 aus Fig. 7c, das MEMS-Bauteil 200 aus Fig. 8a und/oder das MEMS-Bauteil 200 aus Fig. 8b auf dem Substrat gestapelt wird. Desweiteren können, zum Beispiel, zusätzlich nicht ferroelektrische Schichten mittels dieses Verfahrens auf dem Substrat gestapelt werden und/oder bei mehr als nur der ersten ferroelektrischen Schicht durch Anlegen einer Umschaltspannung die Richtung der Polarität umgeschaltet werden.

Die erste ferroelektrische Schicht umfasst ein ferroelektrisches Material, wie hierin beschrieben (die zweite piezoelektrische Schicht kann muss aber nicht ein ferroelektrisches Material umfassen). Das ferroelektrische Material kann, am Beispiel von Al₁₋ₓScₓN, bereits bei Abscheidetemperaturen von 400 °C hergestellt werden und ist damit, wie reines AIN, CMOS-kompatibel. Die hohe elektrische Spannungsfestigkeit von reinem AIN (> 400 V/µm) bleibt auch in Al₁₋ₓScₓN erhalten. Ebenso erhalten bleiben die niedrigen dielektrischen Verluste von in der Regel deutlich unter 1 % [12] und die Möglichkeit, die intrinsische mechanische Verspannung der ferroelektrischen Schichten einzustellen [11]. Das ferroelektrische Material sowie seine Integration, und damit das MEMS-Bauteil, ist CMOS-kompatibel.

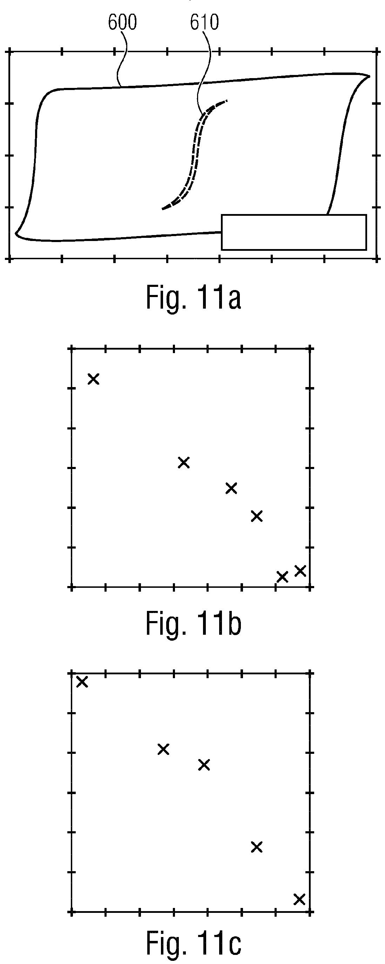

Fig. 11a zeigt ein Diagramm, in dem die elektrische Polarisation über dem elektrischen Feld (P-E Loop), gemessen am ferroelektrischen Al_{0,57}Sc_{0,43}N und PZT 52/48, gemäß einem Beispiel dargestellt wird. Auf der Ordinate wird die Polarisation dargestellt und auf der Abszisse das elektrische Feld. Ein erster P-E Loop 600 stellt die Abhängigkeit der Polarisation vom elektrischen Feld für das ferroelektrische Material Al_{0,57}Sc_{0,43}N dar und ein zweiter P-E Loop 610 stellt die Abhängigkeit der elektrischen Polarisation von einem elektrischen Feld für PZT 52/48 dar. Das ferroelektrische Material Al_{0,57}Sc_{0,43}N ist ein Beispiel für das ferroelektrische Material bestehend aus einem Mischkristall, der AIN und mindestens ein Nitrid eines Übergangsmetalls umfasst, wobei das Übergangsmetall in diesem Fall Scandium ist.

Am Beispiel von Al₁₋ₓScₓN (Mischkristall aus AIN und dem Nitrid des Übergangsmetalls ScN, ein Beispiel für das ferroelektrische Material) wurde entdeckt, dass aus AIN und den Nitriden von Übergangsmetallen bestehende Mischkristalle unter bestimmten Bedingungen ferroelektrisch sind. Ferroelektrizität tritt dann ein, wenn mithilfe eines externen elektrischen Feldes die Energiebarriere zwischen zwei Polarisationszuständen eines Materials überwunden werden kann, ohne zuvor die Durchbruchfeldstärke des Materials (des ferroelektrischen Materials) zu überschreiten. Die gemessene Durchbruchfeldstärke für reines AIN variiert in der Literatur stark, mit Werten zwischen 50 V/µm und 600 V/µm. Untersuchungen ergaben, dass elektrische Durchbrüche bei Feldstärken > 400 V/µm einsetzen. Die Feldstärke, bei der eine räumliche Änderung der Polarisation eintritt, kann durch die Koerzitivfeldstärke E_{c} eines P-E Loops bestimmt werden. P-E Loops stellen die Polarisation P des Materials in Abhängigkeit eines anregenden elektrischen Feldes E dar.

Ob eine räumliche Änderung der Polarisation unterhalb einer Feldstärke von 400 V/µm möglich ist, wird für die betrachteten Materialien (ferroelektrische Materialien) vor allem durch zwei Faktoren bestimmt: zum einen durch das Verhältnis der Anzahl von Al Atomen zur Anzahl an Übergangsmetall-Atomen (siehe Fig. 11c) und zum anderen ist von Bedeutung, inwieweit die ferroelektrische Schicht unter Druck- bzw. Zugspannung steht (siehe Fig. 11b).

In Fig. 11b wird der mittlere Betrag des gemessenen Koerzitivfeldes E_{c} über der mechanischen Verspannung einer Al_{0,73}Sc_{0,27}N Schicht gemäß einem Ausführungsbeispiel der vorliegenden Erfindung dargestellt. Die Ordinate des Diagramms stellt den mittleren Betrag des gemessenen Koerzitivfeldes dar ((Eₑ,₊-E_{c},₋)/2) und auf der Abszisse wird die mechanische Spannung dargestellt. Für unter starker Zugspannung stehende Schichten (des ferroelektrischen Materials) würde sich der notwendige Sc Anteil (der Anteil des Übergangsmetalls) verringern, im Falle von Druckspannung vergrößern. Die Methode zum Einstellen des Sc Gehalts, der mechanischen Verspannung sowie die Herstellung der Schichten allgemein wurde von den Autoren in [11, 12] beschrieben. Das ferroelektrische Material Al_{0,73}Sc_{0,27}N ist ein Beispiel für ein ferroelektrisches Material mit einem Mischkristall, der AIN und mindestens ein Nitrid eines Übergangsmetalls umfasst.

Fig. 11c stellt in einem Diagramm den mittleren Betrag des gemessenen Koerzitivfeldes über dem Sc Gehalt der AIScN-Schicht gemäß einem Ausführungsbeispiel der vorliegenden Erfindung dar. Auf der Ordinate wird der mittlere Betrag des gemessenen Koerzitivfeldes ((E_{c},₊-E_{c},₋)/2) dargestellt und auf der Abszisse wird x in Al₁₋ₓScₓN dargestellt. Die mechanische Verspannung der ferroelektrischen Schichten liegt jeweils innerhalb des Intervalls [0 200 MPa] (das Intervall kann aber auch von -1000 MPa bis 600 MPa gehen, von -400 MPa bis +400 MPa, oder von -200 MPa bis 200 MPa) und ist damit vergleichbar.

Messungen an Al₁₋ₓScₓN in diesem Zusammenhang ergaben, dass ferroelektrisches Schalten der Polarisation beispielsweise ab einem Sc Gehalt von etwa x = 0,27 möglich wird, unter der Voraussetzung, dass die mechanische Verspannung der Schichten (der ferroelektrischen Schichten) nahe dem Übergang von Zug- auf Druckspannung liegt. Für unter stärkerer Zugspannung stehende ferroelektrische Schichten würde sich der notwendige Sc Anteil analog zu Fig. 11b verringern, im Fall von Druckspannung vergrößern. Für eine Al_{0,73}Sc_{0,27}N Schicht sollte die mechanische Spannung zum Beispiel in einem Intervall von -300 MPa bis 2000 MPa liegen, oder von -200 MPa bis 1000 MPa, wobei negative Werte einer Druckspannung entsprechen und positive Werte einer Zugspannung. Für Al_{0,64}Sc_{0,36}N könnte aufgrund des Zusammenhangs in Fig. 11c mehr Druckspannung zugelassen werden, z. B. also mechanische Spannungen in einem Intervall von -600 MPa bis 2000 MPa oder von -500 MPa bis 1000 MPa.

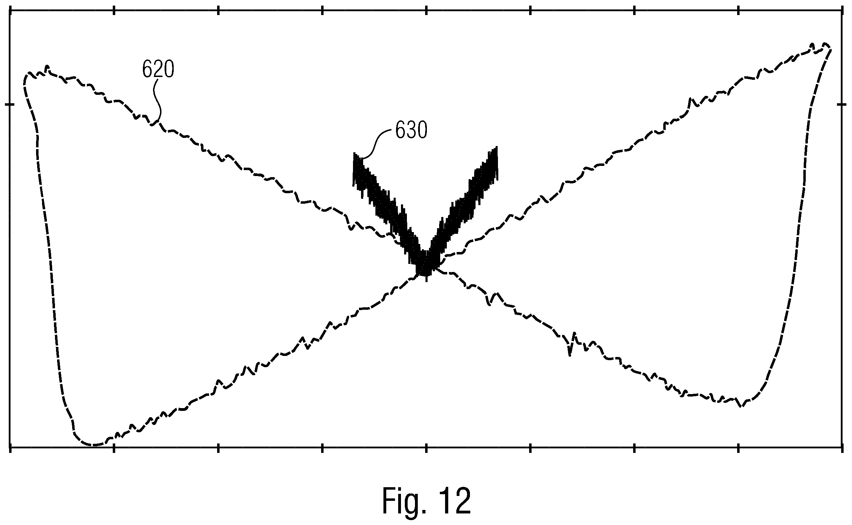

Fig 12 zeigt ein Diagramm, in dem die senkrecht zum Substrat wirkende piezoelektrische Kraft bei einer Elektrodenfläche von 1 mm² für ferroelektrisches Al_{0,57}Sc_{0,43}N (Beispiel für ein ferroelektrisches Material) und PZT (Beispiel für ein ferroelektrisches Material nach dem Stand der Technik, welches nicht CMOS kompatibel und stark nicht-linear ist sowie darüber hinaus eine geringe Durchbruchsspannung hat) im Vergleich gemäß einem Ausführungsbeispiel der vorliegenden Erfindung dargestellt wird. Auf der Ordinate ist die Kraft aufgetragen und auf der Abszisse das elektrische Feld. Die ferroelektrische Kraft wurde aus der per Laserdoppelstrahl-Interferometrie gemessenen Dehnung der Schichten berechnet. Eine erste Kurve 620 stellt das Kraftverhalten gegenüber dem elektrischen Feld des ferroelektrischen AlScN dar und eine zweite Kurve 630 stellt die Abhängigkeit der Kraft vom elektrischen Feld für das Material PZT dar.

Eine weitere herausragende Eigenschaft des ferroelektrischen Materials ist ein sehr großer Bereich, in welchem die aus einem angelegten elektrischen Feld resultierende Kraft linear zu diesem Feld ist (siehe die erste Kurve 620 aus Fig. 12). Als Folge dessen ist ein linearer, bipolarer Antrieb mit hohen Feldstärken von > 50 V/µm möglich. Das ferroelektrische Material hat einen großen Bereich, in dem der Zusammenhang zwischen elektrischem Feld und resultierender Kraft linear ist (Gleiches gilt damit für auf dem Material basierende n-Lagenaktuatoren). Damit ist ein Betrieb mit bipolaren elektrischen Spannungen in dem sehr breiten Bereich zwischen den Koerzitivfeldern E_{c-} und E_{c+} möglich.

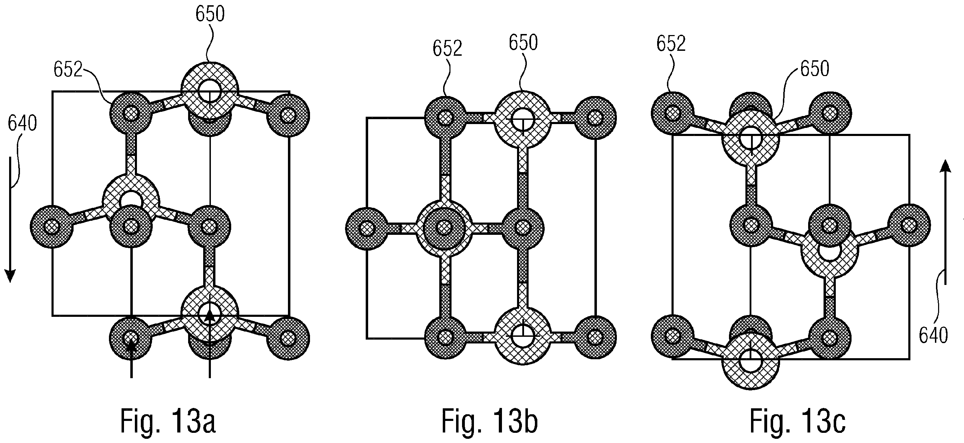

Fig. 13a und Fig. 13c zeigen eine schematische Darstellung einer Einheitszelle eines Wurtzits am Beispiel von Al₁₋ₓScₓN und Fig. 13b zeigt eine schematische Darstellung einer Einheitszelle einer hexagonalen Struktur am Beispiel von Al₁₋ₓScₓN gemäß einem Ausführungsbeispiel der vorliegenden Erfindung. Die elektrische Polarisation P 640 ist dabei parallel zur c-Achse (optische Achse) des Kristalls angeordnet. Je nach der relativen Lage der Metall- 650 und Stickstoff 652-Ebenen zueinander ändert sich das Vorzeichen der Polarisation 640. In Figur 13a hat die Einheitszelle eine negative Polarisation 640, in Fig. 13b sind beide Ebenen (Metall- 650 und Stickstoff 652-Ebene) deckungsgleich (hexagonale Struktur), wodurch die elektrische Polarisation verschwindet und in Fig. 13c ist die Polarisation 640 positiv.

Die Ursache für das entdeckte ferroelektrische Verhalten kann anhand publizierter theoretischer Berechnungen nachvollzogen werden [19]: Infolge eines steigenden Anteils, etwa von Sc in Al₁₋ₓScₓN, nähert sich die Wurtzit Kristallstruktur des AINs energetisch einer hexagonalen Phase, d. h. einer Struktur, in welcher Metall- und Stickstoffatome in einer Ebene angeordnet sind (siehe Fig. 13b). Diese Struktur kann als Übergangsstruktur zwischen den beiden möglichen Polarisationsrichtungen (siehe Fig. 13a und Fig. 13c) der Wurtzit Struktur dienen.

Voraussetzung dafür ist, dass durch Wahl eines entsprechenden Übergangsmetall-Anteils sowie einer entsprechenden mechanischen Verspannung des Materials die beiden Kristallstrukturen energetisch hinreichend nahe beinander liegen, um mittels eines elektrischen Feldes entgegen der Polarisationsrichtung das Energiemaximum der hexagonalen Struktur zu überwinden. Es erfolgt daraufhin ein unmittelbares Schalten der Polarisation in Feldrichtung. Dieser Schaltvorgang ist durch Umkehr des elektrischen Feldes reversibel. Das Material ist damit ferroelektrisch.

Dieser Mechanismus wurde zuvor lediglich für GaScN theoretisch berechnet [19]. Es ist jedoch sehr wahrscheinlich, dass derselbe Effekt auch bei den untersuchten AINbasierten Mischkristallen für das ferroelektrische Verhalten verantwortlich ist. Neben Mischkristallen aus AIN und ScN sind ebenfalls Zusammensetzungen mit den Nitriden anderer Übergangsmetallelemente denkbar, wie YN, TiN, NbN oder CrN bzw. Mischungen dieser.

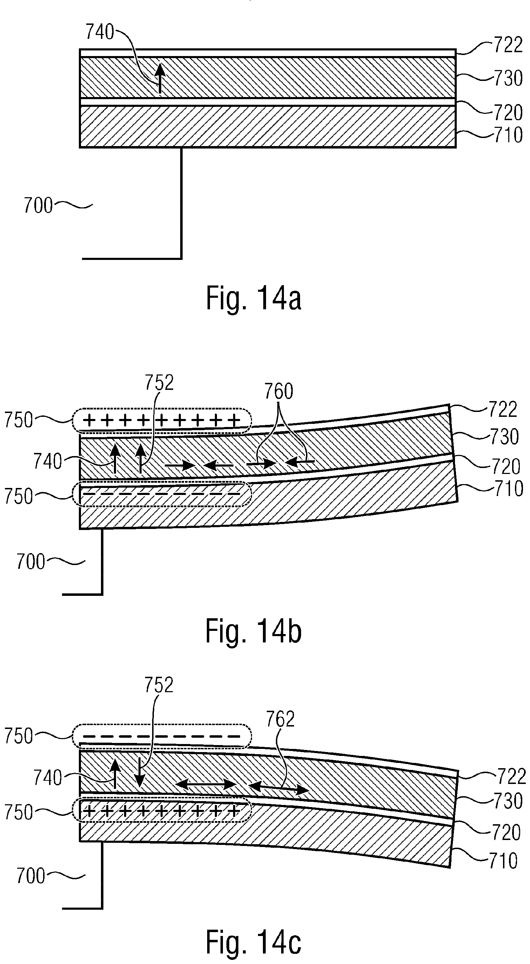

Ferroelektrische Materialien zeichnen sich durch eine räumlich drehbare elektrische Polarisation P aus, deren Richtung durch ein externes elektrisches Feld E bestimmt werden kann. Je nach Ausrichtung der Polarisation gegenüber dem wirkenden elektrischen Feld geht zudem eine Ausdehnung oder Kontraktion des Materials einher (piezoelektrischer Effekt). Dieser Effekt lässt sich in der Aktuatorik einsetzen. In der Mikrosystemtechnik wird dazu beispielsweise ein Plattenkondensator mit ferroelektrischem Dielektrikum auf einer passiven Schicht abgeschieden und strukturiert (siehe Fig. 14a).

Fig. 14a zeigt ein Substrat 700, auf das eine passive Schicht 710 mit einer ersten Elektrode 720 aufgebracht ist gemäß einem Ausführungsbeispiel der vorliegenden Erfindung. Auf die erste Elektrode 720 ist eine ferroelektrische Schicht 730 mit einer zweiten Elektrode 722 angeordnet. Die Schicht 730 hat eine Polarität 740. Dieser Aufbau kann auch mit dem hierin beschriebenen ferroelektrischen Material in der ferroelektrischen Schicht 730 realisiert werden.

In anderen Worten zeigt Fig. 14a eine Skizze eines piezoelektrischen Aktuators bestehend aus einem Parallel-Plattenkondensator mit ferroelektrischem Dielektrikum (ferroelektrische Schicht 730) auf einer passiven Schicht 710. Die passive Schicht 710 kann etwa die Membran eines Ultraschallwandlers oder die eines Lautsprechers sein.

Fig. 14b und Fig. 14c zeigen ebenfalls ein Beispiel für den Einsatz einer ferroelektrischen Schicht als Aktuator gemäß einem Ausführungsbeispiel der vorliegenden Erfindung. Dabei wird der gleiche Aufbau wie aus Fig. 14a (Substrat 700, passive Schicht 710, erste Elektrode 720, ferroelektrische Schicht 730 und zweite Elektrode 722) verwendet. Sowohl die ferroelektrische Schicht 730 aus Fig. 14b als auch die ferroelektrische Schicht 730 aus Fig. 14c weisen eine positive Polarität 740 auf. In Fig. 14b werden allerdings an die erste Elektrode 720 und an die zweite Elektrode 722 andere Spannungen angelegt als bei der ersten Elektrode 720 und der zweiten Elektrode 722 von Fig. 14c, wodurch in Fig. 14b ein anderes elektrisches Feld 750 mit einer elektrischen Feldrichtung 752 entsteht, als in Fig. 14c das elektrische Feld 750 mit der elektrischen Feldrichtung 752.

In Fig. 14b ist die Polarität 740 der ferroelektrischen Schicht 730 der elektrischen Feldrichtung 752 gleichgerichtet, wodurch das ferroelektrische Material 730 eine Stauchung 760 erfährt.

In Fig. 14c ist die Polarität 740 der ferroelektrischen Schicht 730 der elektrischen Feldrichtung 752 gegengerichtet, wodurch die ferroelektrische Schicht 730 eine Dehnung 762 erfährt.

Als Folge der Querkontraktion (Stauchung) bzw. Expansion (Dehnung) des ferroelektrischen Materials bei angelegter Spannung U wird hierbei, je nach Polarisationsrichtung 740, eine Druck- oder Zugspannung innerhalb des Substrats 700 erzeugt und dieses damit verformt (siehe Fig. 14b und Fig. 14c). Die der Verformung zugrundeliegende mechanische Kraft ist durch die piezoelektrischen Koeffizienten des Materials (des ferroelektrischen Materials), dessen Polarisationsrichtung 740 sowie durch die zur Verfügung stehende elektrische Spannung gegeben [1].

Fig. 14b und Fig. 14c zeigen Beispiele für den Einsatz einer ferroelektrischen Schicht als Aktuator gemäß dem Stand der Technik, der ebenfalls für das hierin beschriebene ferroelektrische Material angewendet werden kann. In anderen Worten wird in Fig. 14b und Fig. 14c beschrieben, dass infolge eines externen elektrischen Feldes 750 sich die ferroelektrische Schicht 730 verformt. Je nach Ausrichtung des elektrischen Feldes 750 (elektrische Feldrichtung 752) zur Materialpolarisation, kommt es entweder zu einer Dehnung (siehe Fig. 14c, Dehnung 762) oder einer Stauchung (siehe Fig. 14b, Stauchung 760) der aktiven Schicht (der ferroelektrischen Schicht 730), welche als Folge die passive Schicht 710 staucht oder dehnt, da beide mechanisch gekoppelt sind. Die ferroelektrische Schicht 730 ist mit der passiven Schicht 710 gekoppelt.

Eine Möglichkeit die Kraft für eine feste elektrische Spannung zu steigern, besteht in der Verwendung eines Mehrlagensystems. Bei der Verwendung von n-Lagen ferroelektrischen Materials mit betragsweise identischen ferroelektrischen Koeffizienten, über denen jeweils die verfügbare elektrische Spannung angelegt ist, lässt sich die resultierende Kraft um bis zu den Faktor n steigern [2].

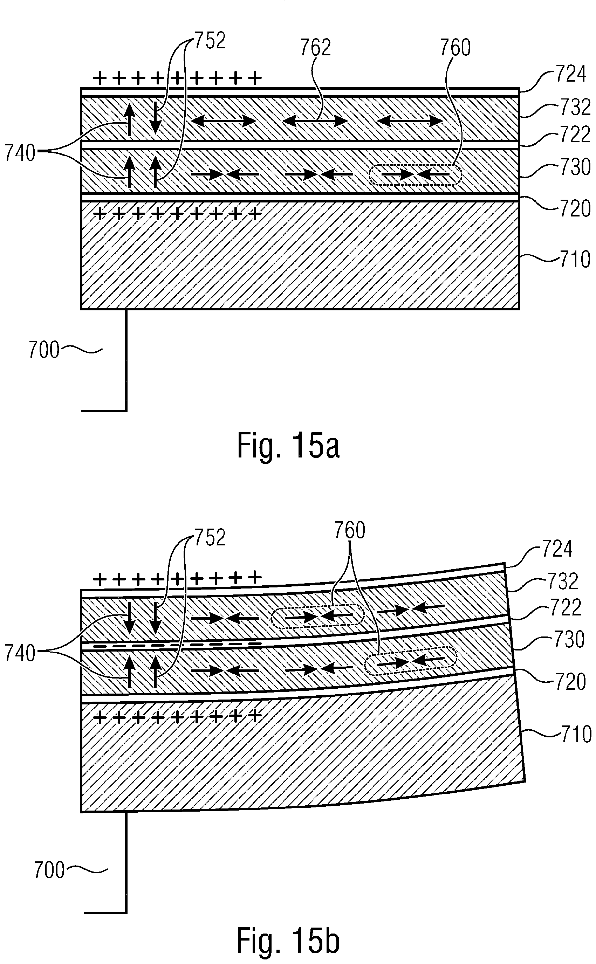

In Fig. 15a und Fig. 15b ist ein ferroelektrisches Mehrlagensystem abgebildet gemäß einem Ausführungsbeispiel der vorliegenden Erfindung. Das ferroelektrische Mehrlagensystem umfasst ein Substrat 700, eine passive Schicht 710, eine erste Elektrode 720, eine zweite Elektrode 722, eine dritte Elektrode 724, eine erste ferroelektrische Schicht 730 und eine zweite ferroelektrische Schicht 732.

In Fig. 15a ist in der ersten ferroelektrischen Schicht 730 die Polarisation 740 der elektrischen Feldrichtung 752 gleichgerichtet, wodurch die erste ferroelektrische Schicht 730 eine Stauchung 760 erfährt und in der zweiten ferroelektrischen Schicht 732 ist die Polarisation 740 der elektrischen Feldrichtung 752 entgegengerichtet, wodurch die zweite ferroelektrische Schicht 732 eine Dehnung 762 erfährt. Somit hebt sich die Dehnung 762 der zweiten ferroelektrischen Schicht 732 mit der Stauchung 760 der ersten ferroelektrischen Schicht 730 so auf, dass es zu keiner Veränderung der passiven Schicht 710 kommt. Fig. 15a illustriert damit die Notwendigkeit einer Polarisationskontrolle der ferroelektrischen Schichten in der dargestellten Ausführung.

In Fig. 15b ist sowohl die Polarisation 740 der ersten ferroelektrischen Schicht 730 der elektrischen Feldrichtung 752 gleichgerichtet als auch die Polarisation 740 der zweiten ferroelektrischen Schicht 732 der elektrischen Feldrichtung 752. Somit erfährt sowohl die erste ferroelektrische Schicht 730 als auch die zweite ferroelektrische Schicht 732 eine Stauchung 760.

In anderen Worten zeigen Fig. 15a und Fig. 15b ein Schema eines einfachen piezoelektrischen Doppellagenaktuators, bestehend aus zwei Plattenkondensatoren mit einer gemeinsamen Elektrode 722. Es wird angenommen, dass die neutrale Ebene innerhalb der passiven Schicht 710 liegt.

In Fig. 15a weisen beide ferroelektrischen Schichten eine identische Polarisationsrichtung 740 auf. Als Folge der wirkenden Kräfte F (Stauchung 760 und Dehnung 762) sollte sich die obere Schicht (die zweite ferroelektrische Schicht 732) dehnen und die untere Schicht (die erste ferroelektrische Schicht 730) stauchen. In Summe heben sich die beiden Effekte (Stauchen 760 und Dehnen 762) weitgehend auf, es wird keine Bewegung induziert.

In Fig. 15b sind die beiden ferroelektrischen Schichten (die erste ferroelektrische Schicht 730 und die zweite ferroelektrische Schicht 732) entgegengesetzt polarisiert 740. Damit werden beide infolge des externen elektrischen Feldes gestaucht. Die gleiche elektrische Spannung vorausgesetzt, wirkt damit die doppelte Kraft einer Einzellage auf die passive Schicht.

Die beiden Ausführungsformen eines Doppellagenaktuators wie in Fig. 15a und Fig. 15b gezeigt, sind zwar aus dem Stand der Technik bekannt, aber können auch auf die hierin beschriebene Erfindung angewendet werden. So kann beispielsweise die erste ferroelektrische Schicht 730 sowie die zweite ferroelektrische Schicht 732 aus Fig. 15a sowie aus Fig. 15b das ferroelektrische Material umfassen.

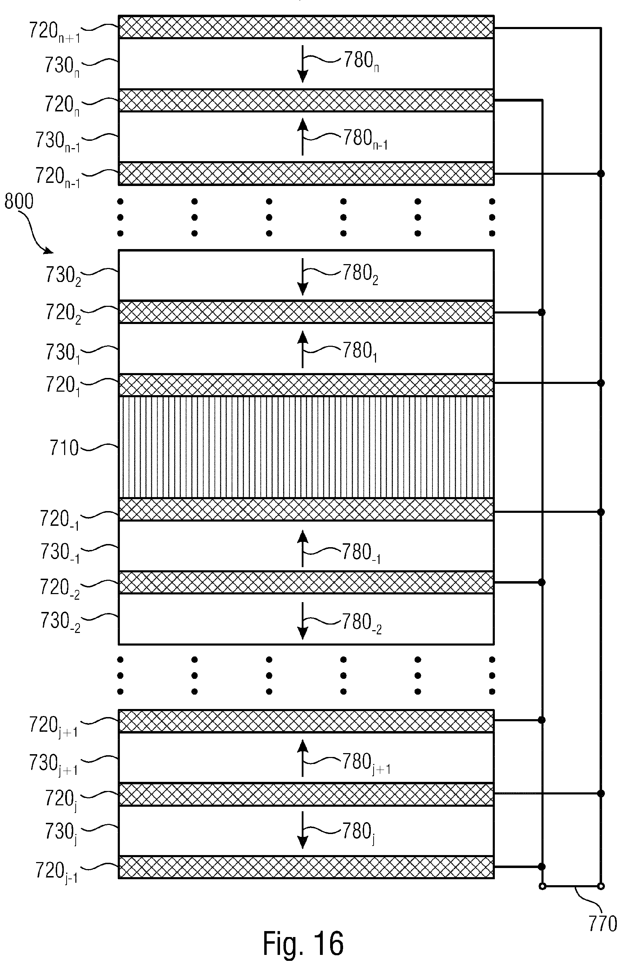

Fig. 16 zeigt eine mögliche Umsetzung eines ferroelektrischen Mehrlagen-Aktuators gemäß einem Ausführungsbeispiel der vorliegenden Erfindung. Der Mehrlagen-Aktuator 800 hat eine passive Schicht 710, ferroelektrische Schichten 730ⱼ bis 730ₙ, Elektroden 720ⱼ₋₁ bis 720ₙ₊₁ und eine Spannungsversorgung 770.

Fig. 16 zeigt eine mögliche Schichtabfolge eines ferroelektrischen Mehrlagen-Aktuators mit alternierend ausgerichteter Polarisation 780ⱼ bis 780ₙ (n bis j ferroelektrische Lagen, j<0, n>0). Im Falle von Ferroelektrika sind nach Anlegen eines ausreichend großen elektrischen Feldes alle aktiven Polarisationsdomänen (Polarisation 780ⱼ bis 780ₙ) entlang des angelegten elektrischen Feldes ausgerichtet. Gezeigt ist eine Realisierung mit aktiven ferroelektrischen Lagen 730ⱼ bis 730ₙ auf beiden Seiten einer passiven Schicht 710. Allgemein kann auf die passive Schicht 710 auch verzichtet werden oder diese nur einseitig beschichtet werden (das heißt z. B. j = 0). In jedem Fall muss die wirkende Kraft von ferroelektrischen Schichten 730ⱼ bis 730ₙ oberhalb der neutralen Ebene (liegt innerhalb der passive Schicht 710) vom Vorzeichen her entgegengesetzt zu darunterliegenden Schichten wirken, um eine mögliche Kompensation der jeweiligen Kräfte zu vermeiden. Ein Beispiel für ein klassisches Ferroelektrika, das in dieser Ausführungsform genutzt werden kann, ist z. B. PZT. Die in Fig. 16 beschriebene Ausführungsform eines Mehrlagen-Aktuators 800 kann auch für das hierin beschriebene ferroelektrische Material (bestehend aus einem Mischkristall, der AIN und mindestens ein Nitrid eines Übergangsmetalls umfasst) realisiert werden, indem mindestens eine der ferroelektrischen Schichten 730ⱼ bis 730ₙ das ferroelektrische Material umfasst.

Ferroelektrika, wie etwa Al₁₋ₓScₓN, lassen sich wie in Abbildung 16 skizziert, ohne zusätzliche Isolationsschichten zu effektiven Multilagen-Aktuatoren zusammenfügen, da dieser Materialklasse eine Ausrichtung seiner elektrischen Polarisation entlang der Feldrichtung externer elektrischer Felder inhärent ist. Gemäß der in Abbildung 16 dargestellten elektrischen Kontaktierung der einzelnen Elektroden 720ⱼ₋₁ bis 720ₙ₊₁ tragen somit sämtliche ferroelektrischen Lagen 730ⱼ bis 730ₙ mit dem idealen Vorzeichen zur Gesamtkraft bei. Neben der Möglichkeit, beide Seiten einer passiven Schicht 710 mit aktiven ferroelektrischen Schichten 730ⱼ bis 730ₙ zu versehen, kann es der Einfachheit halber von Vorteil sein, diese nur einseitig zu beschichten (j = 0) oder die Struktur ausschließlich aus einer ferroelektrischen Multilage nebst Elektroden 720ⱼ₋₁ bis 720ₙ₊₁ zu konstruieren, d. h. ohne passive Schicht 710. In jedem Fall muss für die Wahl einer geeigneten Polarisation 780ⱼ bis 780ₙ die Lage der neutralen Ebene beachtet werden. Schichten oberhalb dieser Ebene müssen ihre Kraft jeweils mit dem entgegengesetzten Vorzeichen einkoppeln, wie darunterliegende.

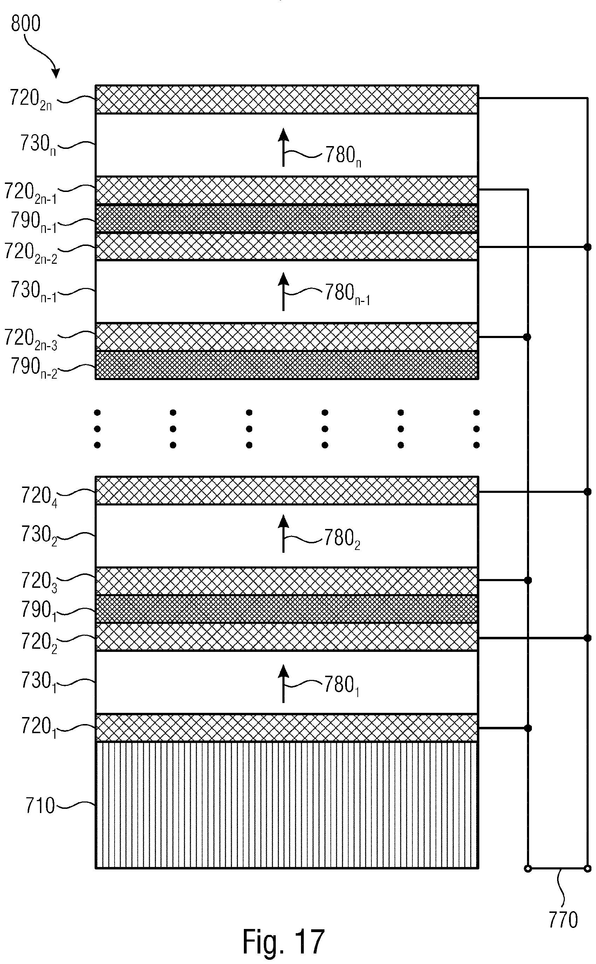

Fig. 17 zeigt eine Umsetzung einer möglichen Schichtabfolge eines piezoelektrischen Mehrlagen-Aktuators 800 mittels elektrisch isolierten Einzellagen gemäß einem Ausführungsbeispiel der vorliegenden Erfindung. Der Mehrlagen-Aktuator 800 hat eine passive Schicht 710, piezoelektrische Schichten 730₁ bis 730ₙ, Elektroden 720₁ bis 720₂ₙ, Isolatoren 790₁ bis 790ₙ₋₁ und eine Spannungsversorgung 770. Die Isolation mit dem Isolator 790₁ bis 790ₙ₋₁ erlaubt den effizienten Einsatz von nicht ferroelektrischen Pyroelektrika (wie z. B. AIN), deren Polarisation 780₁ bis 780ₙ jeweils in dieselbe Richtung zeigt. Der Einfachheit halber ist nur der Fall mit einer einseitig beschichteten passiven Schicht 710 dargestellt. Prinzipiell lassen sich alle diskutierten Prinzipien (beidseitig beschichtete passive Schicht, ohne passive Schicht) mit zusätzlichen Isolatoren 790₁ bis 790ₙ₋₁ realisieren.

Da die Polarisation 780₁ bis 780ₙ von nicht ferroelektrischen Pyroelektrika, wie z. B. AIN, nicht nachträglich geändert werden kann, wird diese allein während der Herstellung des Materials definiert. In mittels ein und desselben Prozesses hergestellten Mehrlagensystemen zeigt die Polarisation aller Schichten (aller piezoelektrischer Schichten 730₁ bis 730ₙ) somit in die gleiche Richtung, idealerweise senkrecht zum Substrat (zur passiven Schicht 710). Um einen effektiven Antrieb zu gewährleisten, muss daher auch das anregende elektrische Feld für alle Einzellagen in dieselbe Richtung zeigen. Daher ist es notwendig, die einzelnen Kondensatorstrukturen der Multilagen elektrisch zu trennen (siehe Fig. 17). Auch wenn der Mehrlagen-Aktuator 800 aus Fig. 17, wie bekannt aus dem Stand der Technik, Nachteile gegenüber dem Einsatz von Ferroelektrika besitzt (wie z. B. die Notwendigkeit mindestens zweier zusätzlicher Schichten, nämlich die eines Isolators und einer weiteren Elektrode pro ferroelektrischer Schicht), kann der Mehrlagen-Aktuator 800 trotzdem auch ein Ausführungsbeispiel der hierin beschriebenen Erfindung sein. Dies wird bewerkstelligt, indem die mindestens eine der piezoelektrischen Schichten 730₁ bis 730ₙ das ferroelektrische Material umfasst.

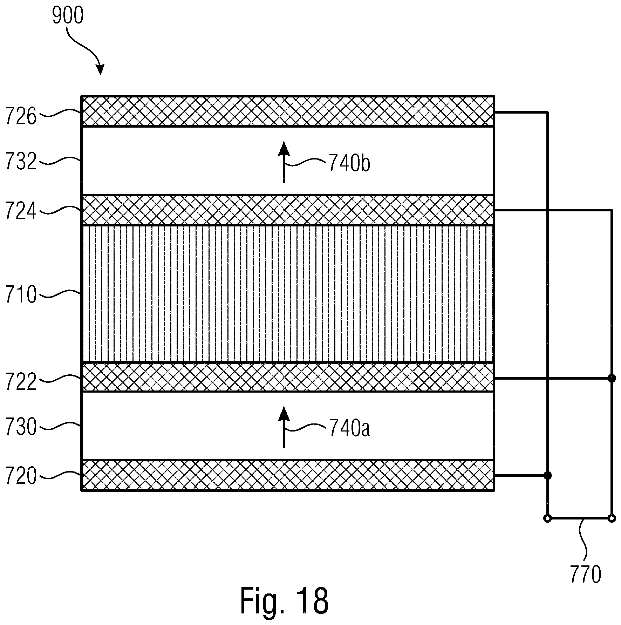

Fig. 18 zeigt eine Umsetzung einer möglichen Schichtabfolge eines piezoelektrischen Bimorphs 900 gemäß einem Ausführungsbeispiel der vorliegenden Erfindung. Das Bimorph 900 hat eine passive Schicht 710, eine erste piezoelektrische Schicht 730, eine zweite piezoelektrische Schicht 732, eine erste Elektrode 720, eine zweite Elektrode 722, eine dritte Elektrode 724, eine vierte Elektrode 726 und eine Spannungsversorgung 770. Die passive Schicht 710 ist optional. Die Anzahl der piezoelektrischen Schichten ist auf n = 2 begrenzt und sowohl die erste piezoelektrische Schicht 730 weist eine Polarität 740a auf als auch die zweite piezoelektrische Schicht 732 weist eine Polarität 740b auf. Diese Schichtabfolge eines piezoelektrischen Bimorphs wird z. B. gemäß dem Stand der Technik bereits für AIN verwendet. Es ist aber auch möglich, dass das ferroelektrische Material, wie hierin beschrieben, verwendet wird. Somit kann das Bimorph 900 aus Fig. 18 auch ein Ausführungsbeispiel gemäß der hierin beschriebenen Erfindung sein, indem zumindest eine der beiden piezoelektrischen Schichten (die erste piezoelektrischen Schicht 730 und/oder die zweite piezoelektrische Schicht 732) das ferroelektrische Material umfassen, das einen Mischkristall hat, der AIN und mindestens ein Nitrid eines Übergangsmetalls umfasst.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

### Referenzen

[1] T. Ikeda,"Fundamentals of Piezoelectricity", Oxford University Press, 1990.
[2] R. G. Ballas, "Piezoelectric Multilayer Beam Bending Actuators", Springer, 2007.
[3] C. Randall, A. Kelnberger, G. Y. Yang, R. E. Eitel, and T. R. Shrout, "High Strain Piezoelectric Multilayer Actuators: A Material Science and Engineering Challenge," J. Electroceramics, vol. 14, no. 3, pp. 177-191, 2005.
[4] L. M. Sanchez, A. D. Grobicki, G. L. Smith, J. S. Pulskamp, I. Takeuchi, and R. G. Polcawich, "Texture control in lead zirconate titanate multilayer thin films," IEEE Trans. Ultrason. Ferroelectr. Freq. Control, vol. 61, no. 4, pp. 654-661, 2014.
[S] N. R. Harris et al., "A multilayer thick-film PZT actuator for MEMs applications," Sensors Actuators, A Phys., vol. 132, no. 1 SPEC. ISS., pp. 311-316, 2006.
[6] Y. Lu, A. Heidari, and D. A. Horsley, "A High Fill-Factor Annular Array of High Frequency Piezoelectric Micromachined Ultrasonic Transducers," J. Microelectromechanical Syst., vol. 24, no. 4, pp. 904-913, 2015.
[7] N. Sinha et al., "Piezoelectric aluminum nitride nanoelectromechanical actuators," Appl. Phys. Lett., vol. 95, no. 5, 2009.
[8] E. Milyutin et al., "Sputtering of (001)AIN thin films: Control of polarity by a seed layer," J. Vac. Sci. Technol. B Microelectron. Nanom. Struct., vol. 28, no. May, p. L61, 2010.
[9] M. Akiyama, T. Kamohara, K. Kano, A. Teshigahara, and N. Kawahara, "Influence of oxygen concentration in sputtering gas on piezoelectric response of aluminum nitride thin films," Appl. Phys. Lett., vol. 93, no. 2, pp. 6-9, 2008.
[10] T. Mizuno et al., "Germanium Aluminium Nitride thin films for piezo-MEMS devices," Transducers, Taiwan, 2017.
[11] S. Fichtner, T. Reimer, S. Chemnitz, F. Lofink, and B. Wagner, "Stress controlled pulsed direct current co-sputtered Al1-xScxN as piezoelectric phase for micromechanical sensor applications," APL Mater., vol. 3, no. 11, 2015.
[12] S. Fichtner et al., "Identifying and overcoming the interface originating c-axis instability in highly Sc enhanced AIN for piezoelectric micro-electromechanical systems," J. Appl. Phys., vol. 122, no. 3, p. 35301, 2017.
[13] M. Akiyama, T. Kamohara, K. Kano, A. Teshigahara, Y. Takeuchi,and N. Kawahara, "Enhancement of piezoelectric response in scandium aluminum nitride alloy thin films prepared by dual reactive cosputtering," Adv. Mater., vol. 21,no. 5, pp. 593-596, 2009.
[14] M. Akiyama et al., "Piezoelectric thin film, piezoelectric material, and fabrication method of piezoelectric thin film and piezoelectric material, and piezoelectric resonator, actuator element, and physical sensor using piezoelectric thin film," US7758979B2, 2010.
[15] P. M. Mayrhofer et al., "Microstructure and piezoelectric response of YxAl1-xN thin films," Acta Mater., vol. 100, pp. 81-89, 2015.
[16] A. Zukauskaite et al., "YxAI1-xN thin films," J. Phys. D. Appl. Phys., vol. 45, no. 42, p. 422001, 2012.
[17] V. V. Felmetsger and M. K. Mikhov, "Reactive sputtering of highly c-axis textured Ti-doped AIN thin films," IEEE Int. Ultrason. Symp. /US, pp. 782-785, 2012.
[18] E. Iborra, J. Capilla, J. Olivares, M. Clement, and V. Felmetsger, "Piezoelectric and electroacoustic properties of Ti-doped AIN thin films as a function of Ti content," IEEE Int. Ultrason. Symp. /US, pp. 2734-2737, 2012.
[19] S. Zhang,D. Holec, W. Y. Fu, C. J. Humphreys, and M. A. Moram, "Tunable optoelectronic and ferroelectric properties in Sc-based III-nitrides," J. Appl. Phys., vol. 114, no. 13, 2013.
[20] F. Senger et al., "Mikromechanisches Bauteil und Verfahren zur Herstellung eines piezoelektrischen mikromechanischen Bauteils", DE102015213714A1, 2015.
[21] D. J. Meyer et al., "Method for Fabricating Suspended MEMS Structures", US20160304340A1, 2015.
[22] A. R. Clerici et al., "MEMS-Leiterplattenmodul mit integrierter piezoelektrischer Struktur sowie Schallwandleranordnung", DE102015116640A1, 2015.
[23] A. R. Clerici et al., "Mikro-elektromechanischer Schallwandler mit schallenergiereflektierender Zwischenschicht", DE102013114826A1, 2013.
[24] N. Singh et al., "device arrangement", WO2017/065691A1, 2015.
[25] M. Akiyama et al., "Piezoelektrischer dünner Film, piezoelektrisches Material und Herstellungsverfahren für piezoelektrischen dünnen Film und piezoelektrisches Material, und piezoelektrischer Resonator, Schalterelement und physikalischer Fühler, die piezoelektrischen dünnen Film verwenden", DE102008025691A1, 2008

## Patentansprüche

1. Ferroelektrisches Material (100); mit
einem Mischkristall (110), der AIN (120) und mindestens ein Nitrid eines Übergangsmetalls (130) umfasst;
wobei der Anteil des Nitrids des Übergangsmetalls (130) so gewählt ist, dass eine Richtung einer anfänglichen oder spontanen Polarität (140, 142, 260, 640, 740, 740a, 740b, 780) des ferroelektrischen Materials (100) durch Anlegen einer Umschaltspannung (150) umschaltbar ist, wobei die Umschaltspannung (150) unterhalb einer Durchbruchspannung des ferroelektrischen Materials (100) liegt,
wobei das Verhältnis zwischen einer Anzahl an Übergangsmetall-Atomen zu einer Summe aus der Anzahl an Übergangsmetall-Atomen und einer Anzahl an Aluminium Atomen in einem Bereich größer oder gleich 0,3 und kleiner oder gleich 0,36 liegt.

2. Ferroelektrisches Material (100) nach Anspruch 1, wobei das ferroelektrische Material (100) eine mechanische Spannung aufweist, die zwischen einem ersten Wert einer Druckspannung und einem zweiten Wert einer Zugspannung liegt, wobei ein Absolutwert des ersten Wertes niedriger ist als ein Absolutwert des zweiten Wertes.

3. Ferroelektrisches Material (100) nach einem der Ansprüche 1 bis 2, wobei die Richtung der Polarität (140, 142, 260, 640, 740, 740a, 740b, 780) des ferroelektrischen Materials (100) nach einem Entfernen der angelegten Umschaltspannung (150) erhalten bleibt.

4. Verfahren, mit folgenden Schritten:
Bereitstellen eines Mischkristalls (110) mit einer anfänglichen oder spontanen Polarität, wobei der Mischkristall (110) AIN (120) und mindestens ein Nitrid eines Übergangsmetalls (130) umfasst,
wobei der Anteil des Nitrids des Übergangsmetalls (130) so gewählt ist, dass eine Richtung der anfänglichen oder spontanen Polarität (140, 142, 260, 640, 740, 740a, 740b, 780) des ferroelektrischen Materials (100) durch Anlegen einer Umschaltspannung (150) umschaltbar ist, wobei die Umschaltspannung (150) unterhalb einer Durchbruchspannung des ferroelektrischen Materials (100) liegt; und
Anlegen einer Umschaltspannung (150) an den Mischkristall, so dass die Richtung der anfänglichen oder spontanen Polarität (140, 142, 260, 640, 740, 740a, 740b, 780) des Mischkristalls (110) umgekehrt wird.

5. Verfahren nach Anspruch 4, wobei
das Bereitstellen folgendes umfasst: Bereitstellen eines MEMS-Bauteils (200) mit zumindest einer ferroelektrischen Schicht (210), die den Mischkristall umfasst, und mit zumindest zwei Elektroden (230, 232), zwischen denen die ferroelektrische Schicht (210) angeordnet ist, und
das Anlegen der Umschaltspannung (150) an den Mischkristall ein Anlegen der Umschaltspannung an die Elektroden umfasst.

6. MEMS-Bauteil (200) mit einem ferroelektrischen Material (100) nach einem der Ansprüche 1 bis 3.

7. MEMS-Bauteil (200) nach Anspruch 6, mit
einer ersten ferroelektrischen Schicht (210, 730), die das ferroelektrische Material (100) umfasst,
einer ersten Elektrode (230, 722), die auf einer ersten Oberfläche (220) der ersten ferroelektrischen Schicht (210, 730) angeordnet ist, und
einer zweiten Elektrode (232, 720), die auf einer zweiten Oberfläche (221) der ersten ferroelektrischen Schicht (210, 730) angeordnet ist, wobei die zweite Oberfläche (221) der ersten Oberfläche (220) gegenüber liegt; und
zum Beispiel einer passiven Schicht (231c, 240, 710), die an der zweiten Elektrode (232, 720) angeordnet ist.

8. MEMS-Bauteil (200) nach Anspruch 7, mit
einer zweiten ferroelektrischen Schicht (212, 732), die das ferroelektrische Material (100) umfasst und die auf der ersten Elektrode (230, 722), gegenüber der ersten ferroelektrischen Schicht (210, 730), angeordnet ist, und
einer dritten Elektrode (234), die auf einer ersten Oberfläche (222) der zweiten ferroelektrischen Schicht (212, 732) angeordnet ist, wobei die erste Oberfläche (222) der zweiten ferroelektrischen Schicht (212, 732) der ersten Elektrode (230, 722) abgewandt angeordnet ist,
wobei die Polarität der ersten ferroelektrischen Schicht 210 in entgegengesetzte Richtung als die Polarität der zweiten ferroelektrischen Schicht 212 zeigt.

9. MEMS-Bauteil (200) nach Anspruch 8, wobei die erste Elektrode (230, 722) eine erste Elektrodenschicht (231a, 724) und eine zweite Elektrodenschicht (231b, 722) aufweist, und
wobei zwischen der ersten (231a, 724) und der zweiten Elektrodenschicht (231b, 722) eine Isolationsschicht (231c, 240, 710) angeordnet ist, in der eine neutrale Ebene liegt; oder
wobei die erste Elektrode (230, 722) eine erste Elektrodenschicht (231a, 724) und eine zweite Elektrodenschicht (231b, 722)aufweist, und
wobei zwischen der ersten (231a, 724) und der zweiten Elektrodenschicht (231b, 722) eine passive Schicht (231c, 240, 710) angeordnet ist, in der eine neutrale Ebene liegt.

10. MEMS-Bauteil (200) nach Anspruch 8 oder Anspruch 9, mit
einer dritten ferroelektrischen Schicht (214), die auf der dritten Elektrode (234), gegenüber der zweiten ferroelektrischen Schicht (212, 732), angeordnet ist,
einer vierten Elektrode (236), die auf einer ersten Oberfläche (223) der dritten ferroelektrischen Schicht (214) angeordnet ist, wobei die erste Oberfläche (223) der dritten ferroelektrischen Schicht (214) der dritten Elektrode (234) abgewandt angeordnet ist,
einer vierten ferroelektrischen Schicht (216), die auf der zweiten Elektrode (232, 720), gegenüber der ersten ferroelektrischen Schicht (210, 730), angeordnet ist, und
einer fünften Elektrode (238), die auf einer ersten Oberfläche (224) der vierten ferroelektrischen Schicht (216) der zweiten Elektrode (232, 720) abgewandt angeordnet ist.

11. MEMS-Bauteil (200) nach einem der Ansprüche 6 bis 10, wobei das MEMS-Bauteil (200) einen Mehrlagen-MEMS Aktuator, einen Mehrlagen-MEMS Sensor oder einen Mehrlagen-MEMS Generator umfasst, und
wobei das MEMS-Bauteil eine Schichtabfolge mit alternierend ausgerichteter Polarisation aufweist.

12. MEMS-Vorrichtung (300), mit
einem Substrat (310), und
einem ersten MEMS-Bauteil (200) nach einem der Ansprüche 7 bis 11, wobei die passive Schicht (231c, 240, 710) des MEMS-Bauteils (200) an dem Substrat (310) auslenkbar angeordnet ist.

13. MEMS-Vorrichtung (300) nach Anspruch 12, mit
einem zweiten MEMS-Bauteil (200) nach einem der Ansprüche 7 bis 11, wobei die erste und die zweite passive Schicht (231c, 240, 710) eine Gemeinschaft sind und die Elektroden und die ferroelektrischen Schichten des ersten und des zweiten MEMS-Bauteils (200) parallel angeordnet sind.

14. Verfahren zur Herstellung eines MEMS-Bauteils (200), mit folgenden Schritten:
Stapeln einer ersten Elektrode (232, 720), einer ersten ferroelektrischen Schicht (210, 730), einer zweiten Elektrode (230, 722), einer zweiten piezoelektrischen Schicht (212, 732) und einer dritten Elektrode (234) in dieser Reihenfolge, wobei die erste ferroelektrische Schicht (210, 730) und die zweite piezoelektrische Schicht (212, 732) die gleiche Polarisationsrichtung (140, 142, 260, 640, 740, 740a, 740b, 780) aufweisen und wobei zumindest die erste ferroelektrische Schicht (210, 730) ferroelektrisches Material (100) mit
einem Mischkristall (110), der AIN (120) und mindestens ein Nitrid eines Übergangsmetalls (130) umfasst, umfassen;
wobei der Anteil des Nitrids des Übergangsmetalls (130) so gewählt ist, dass eine Richtung einer Polarität (140, 142, 260, 640, 740, 740a, 740b, 780) des ferroelektrischen Materials (100) durch Anlegen einer Umschaltspannung (150) umschaltbar ist, wobei die Umschaltspannung (150) unterhalb einer Durchbruchspannung des ferroelektrischen Materials (100) liegt; und
wobei das Verfahren ferner folgenden Schritt aufweist:
Anlegen einer Umschaltspannung (150) an die erste Elektrode (232, 720) und an die zweite Elektrode (230, 722), wobei die Polarisationsrichtung (140, 142, 260, 640, 740, 740a, 740b, 780) der ersten ferroelektrischen Schicht (210, 730) umgekehrt wird, so dass die Polarisationsrichtung (140, 142, 260, 640, 740, 740a, 740b, 780) der ersten ferroelektrischen Schicht (210, 730) umgekehrt wird.

15. Verfahren nach Anspruch 14,
bei dem die erste Elektrode (232, 720), die erste ferroelektrische Schicht (210, 730), die zweite Elektrode (230, 722), die zweite piezoelektrische Schicht (212, 732) und die dritte Elektrode (234) auf einem Substrat (310) gestapelt werden, und
wobei das Verfahren ferner folgenden Schritt aufweist:
Integrieren einer oder mehrerer Schaltungskomponenten einer integrierten Schaltung unter Verwendung eines CMOS-Prozesses in dem Substrat (310) vor oder nach dem Stapeln der ersten Elektrode (232, 720), der ersten ferroelektrischen Schicht (210, 730), der zweiten Elektrode (230, 722), der zweiten piezoelektrischen Schicht (212, 732) und der dritten Elektrode (234) und
wobei das Substrat zum Beispiel entweder an die erste Elektrode oder die dritte Elektrode anschließt.

## Claims

1. A ferroelectric material (100); comprising
a mixed crystal (110) comprising AIN (120) and at least one nitride of a transition metal (130);
wherein the proportion of the nitride of the transition metal (130) is selected such that a direction of an initial or spontaneous polarity (140, 142, 260, 640, 740, 740a, 740b, 780) of the ferroelectric material (100) is switchable by applying a switchover voltage (150), the switchover voltage (150) being below a breakdown voltage of the ferroelectric material (100),
wherein the ratio of a number of transition metal atoms to a sum of the number of transition metal atoms and a number of aluminum atoms ranges between greater than or equal to 0.3 and less than or equal to 0.36.

2. The ferroelectric material (100) as claimed in claim 1, the ferroelectric material (100) comprising a mechanical stress that lies between a first value of a compressive stress and a second value of a tensile stress, wherein an absolute value of the first value is lower than an absolute value of the second value.

3. The ferroelectric material (100) as claimed in any of claims 1 to 2, wherein the direction of polarity (140, 142, 260, 640, 740, 740a, 740b, 780) of the ferroelectric material (100) is maintained after removal of the applied switchover voltage (150).

4. A method comprising:
providing a mixed crystal (110) having an initial or spontaneous polarity, wherein the mixed crystal (110) comprises AIN (120) and at least one nitride of a transition metal (130),
wherein the proportion of the nitride of the transition metal (130) is selected such that a direction of the initial or spontaneous polarity (140, 142, 260, 640, 740, 740a, 740b, 780) of the ferroelectric material (100) is switchable by applying a switchover voltage (150), the switchover voltage (150) being below a breakdown voltage of the ferroelectric material (100); and
applying a switchover voltage (150) to the mixed crystal, so that the direction of the initial or spontaneous polarity (140, 142, 260, 640, 740, 740a, 740b, 780) of the mixed crystal (110) is reversed.

5. The method as claimed in claim 4, wherein
said providing includes: providing a MEMS component (200) comprising at least one ferroelectric layer (210) including the mixed crystal, and comprising at least two electrodes (230, 232) which have the ferroelectric layer (210) arranged between them, and
said applying of the switchover voltage (150) to the mixed crystal comprises applying the switchover voltage to the electrodes.

6. An MEMS component (200) comprising a ferroelectric material (100) as claimed in any of claims 1 to 3.

7. The MEMS component (200) as claimed in claim 6, comprising
a first ferroelectric layer (210, 730) comprising the ferroelectric material (100),
a first electrode (230, 722) disposed on a first surface (220) of the first ferroelectric layer (210, 730), and
a second electrode (232, 720) disposed on a second surface (221) of the first ferroelectric layer (210, 730), the second surface (221) being opposite the first surface (220), and
a passive layer (231c, 240, 710), for example, disposed on the second electrode (232, 720).

8. The MEMS component (200) as claimed in claim 7, comprising
a second ferroelectric layer (212, 732) including the ferroelectric material (100) and disposed on the first electrode (230, 722) opposite the first ferroelectric layer (210, 730), and
a third electrode (234) disposed on a first surface (222) of the second ferroelectric layer (212, 732), the first surface (222) of the second ferroelectric layer (212, 732) being disposed to face away from the first electrode (230, 722),
wherein the polarity of the first ferroelectric layer 210 points in a direction opposite to that of the polarity of the second ferroelectric layer 212.

9. The MEMS component (200) as claimed in claim 8, wherein the first electrode (230, 722) comprises a first electrode layer (231a, 724) and a second electrode layer (231b, 722), and
wherein an insulating layer (231c, 240, 710) in which a neutral plane lies is disposed between the first (231a, 724) and second electrode layers (231b, 722), or
wherein the first electrode (230, 722) comprises a first electrode layer (231a, 724) and a second electrode layer (231b, 722), and
wherein a passive layer (231c, 240, 710) in which a neutral plane lies is disposed between the first (231a, 724) and second electrode layers (231b, 722).

10. The MEMS component (200) as claimed in claim 8 or claim 9, comprising
a third ferroelectric layer (214) disposed at the third electrode (234), opposite the second ferroelectric layer (212, 732),
a fourth electrode (236) disposed on a first surface (223) of the third ferroelectric layer (214), the first surface (223) of the third ferroelectric layer (214) being disposed to face away from the third electrode (234),
a fourth ferroelectric layer (216) disposed on the second electrode (232, 720), opposite the first ferroelectric layer (210, 730), and
a fifth electrode (238) disposed on a first surface (224) of the fourth ferroelectric layer (216) to face away from the second electrode (232, 720).

11. The MEMS component (200) as claimed in any of claims 6 to 10, wherein the MEMS component (200) comprises a multilayer MEMS actuator, a multilayer MEMS sensor or a multilayer MEMS generator, and
wherein the MEMS component comprises a sequence of layers with alternately aligned polarisation.

12. An MEMS device (300), comprising
a substrate (310), and
a first MEMS component (200) as claimed in any of claims 7 to 11, wherein the passive layer (231c, 240, 710) of the MEMS component (200) is deflectably disposed on the substrate (310).

13. The MEMS device (300) as claimed in claim 12, comprising
a second MEMS component (200) as claimed in any of claims 7 to 11, wherein the first and second passive layers (231c, 240, 710) are a community, and the electrodes and ferroelectric layers of the first and second MEMS components (200) are arranged in parallel.

14. A method of producing a MEMS component (200), comprising:
stacking a first electrode (232, 720), a first ferroelectric layer (210, 730), a second electrode (230, 722), a second piezoelectric layer (212, 732) and a third electrode (234) in this order, wherein the first ferroelectric layer (210, 730) and the second piezoelectric layer (212, 732) have the same direction of polarization (140, 142, 260, 640, 740, 740a, 740b, 780), and wherein at least the first ferroelectric layer (210, 730) comprises a ferroelectric material (100) comprising
a mixed crystal (110) comprising AIN (120) and at least one nitride of a transition metal (130);
wherein the proportion of the nitride of the transition metal (130) is selected such that a direction of a polarity (140, 142, 260, 640, 740, 740a, 740b, 780) of the ferroelectric material (100) is switchable by applying a switchover voltage (150), the switchover voltage (150) being below a breakdown voltage of the ferroelectric material (100); and
the method further comprising:
applying a switchover voltage (150) to the first electrode (232, 720) and to the second electrode (230, 722), wherein the polarization direction (140, 142, 260, 640, 740, 740a, 740b, 780) of the first ferroelectric layer (210, 730) is reversed, so that the polarization direction (140, 142, 260, 640, 740, 740a, 740b, 780) of the first ferroelectric layer (210, 730) is reversed.

15. The method as claimed in claim 14,
wherein the first electrode (232, 720), the first ferroelectric layer (210, 730), the second electrode (230, 722), the second piezoelectric layer (212, 732) and the third electrode (234) are stacked on a substrate (310), and
the method further comprising:
integrating one or more circuit components of an integrated circuit using a CMOS process in the substrate (310) before or after stacking the first electrode (232, 720), the first ferroelectric layer (210, 730), the second electrode (230, 722), the second piezoelectric layer (212, 732) and the third electrode (234), and
wherein the substrate exemplarily adjoins either the first electrode or the third electrade.

## Revendications

1. Matériau ferroélectrique (100), avec
un cristal mixte (110) qui comporte de l'AIN (120) et au moins un nitrure d'un métal de transition (130);
dans lequel la part du nitrure du métal de transition (130) est choisie de sorte qu'une direction d'une polarité initiale ou spontanée (140, 142, 260, 640, 740, 740a, 740b, 780) du matériau ferroélectrique (100) puisse être commutée par application d'une tension de commutation (150), dans lequel la tension de commutation (150) se situe au-dessous d'une tension de claquage du matériau ferroélectrique (100),
dans lequel le rapport entre un nombre d'atomes de métal de transition et une somme du nombre d'atomes de métal de transition et d'un nombre d'atomes d'aluminium se situe dans une plage supérieure ou égale à 0,3 et inférieure ou égale à 0,36.

2. Matériau ferroélectrique (100) selon la revendication 1, dans lequel le matériau ferroélectrique (100) présente une tension mécanique qui se situe entre une première valeur de contrainte de compression et une deuxième valeur de contrainte de traction, dans lequel une valeur absolue de la première valeur est inférieure à une valeur absolue de la deuxième valeur.

3. Matériau ferroélectrique (100) selon l'une des revendications 1 à 2, dans lequel la direction de polarité (140, 142, 260, 640, 740, 740a, 740b, 780) du matériau ferroélectrique (100) reste maintenue après une élimination de la tension de commutation (150) appliquée.

4. Procédé, aux étapes suivantes consistant à:
mettre à disposition un cristal mixte (110) avec une polarité initiale ou spontanée, où le cristal mixte (110) comporte de l'AIN (120) et au moins un nitrure d'un métal de transition (130),
dans lequel la part du nitrure du métal de transition (130) est choisie de sorte qu'une direction de la polarité initiale ou spontanée (140, 142, 260, 640, 740, 740a, 740b, 780) du matériau ferroélectrique (100) puisse être commutée par application d'une tension de commutation (150), dans lequel la tension de commutation (150) se situe au-dessous d'une tension de claquage du matériau ferroélectrique (100); et
appliquer une tension de commutation (150) au cristal mixte de sorte que la direction de la polarité initiale ou spontanée (140, 142, 260, 640, 740, 740a, 740b, 780) du cristal mixte (110) soit inversée.

5. Procédé selon la revendication 4, dans lequel
la mise à disposition comporte ce qui suit: mettre à disposition un composant MEMS (200) avec au moins une couche ferroélectrique (210) qui comporte le cristal mixte, et avec au moins deux électrodes (230, 232) entre lesquelles est disposée la couche ferroélectrique (210), et
l'application de la tension de commutation (150) au cristal mixte comporte le fait d'appliquer la tension de commutation aux électrodes.

6. Composant MEMS (200) avec un matériau ferroélectrique (100) selon l'une des revendications 1 à 3.

7. Composant MEMS (200) selon la revendication 6, avec
une première couche ferroélectrique (210, 730) qui comporte le matériau ferroélectrique (100),
une première électrode (230, 722) qui est disposée sur une première surface (220) de la première couche ferroélectrique (210, 730), et
une deuxième électrode (232, 720) qui est disposée sur une deuxième surface (221) de la première couche ferroélectrique (210, 730), où la deuxième surface (221) est opposée à la première surface (220); et
par exemple une couche passive (231c, 240, 710) qui est disposée sur la deuxième électrode (232, 720).

8. Composant MEMS (200) selon la revendication 7, avec
une deuxième couche ferroélectrique (212, 732) qui comporte le matériau ferroélectrique (100) et qui est disposée sur la première électrode (230, 722), opposée à la première couche ferroélectrique (210, 730), et
une troisième électrode (234) qui est disposée sur une première surface (222) de la deuxième couche ferroélectrique (212, 732), où la première surface (222) de la deuxième couche ferroélectrique (212, 732) est disposée éloignée de la première électrode (230, 722),
dans lequel la polarité de la première couche ferroélectrique 210 pointe dans la direction opposée à la polarité de la deuxième couche ferroélectrique 212.

9. Composant MEMS (200) selon la revendication 8, dans lequel la première électrode (230, 722) présente une première couche d'électrode (231a, 724) et une deuxième couche d'électrode (231b, 722), et
dans lequel est disposée, entre la première (231a, 724) et la deuxième couche d'électrode (231b, 722), une couche d'isolation (231c, 240, 710) dans laquelle se situe un plan neutre; ou
dans lequel la première électrode (230, 722) présente une première couche d'électrode (231a, 724) et une deuxième couche d'électrode (231b, 722), et
dans lequel est disposée, entre la première (231a, 724) et la deuxième couche d'électrode (231b, 722), une couche passive (231c, 240, 710) dans laquelle se situe un plan neutre.

10. Dispositif MEMS (200) selon la revendication 8 ou la revendication 9, avec
une troisième couche ferroélectrique (214) qui est disposée sur la troisième électrode (234), opposée à la deuxième couche ferroélectrique (212, 732),
une quatrième électrode (236) qui est disposée sur une première surface (223) de la troisième couche ferroélectrique (214), où la première surface (223) de la troisième couche ferroélectrique (214) est disposée éloignée de la troisième électrode (234),
une quatrième couche ferroélectrique (216) qui est disposée sur la deuxième électrode (232, 720), opposée à la première couche ferroélectrique (210, 730), et
une cinquième électrode (238) qui est disposée sur une première surface (224) de la quatrième couche ferroélectrique (216) éloignée de la deuxième électrode (232, 720).

11. Composant MEMS (200) selon l'une des revendications 6 à 10, dans lequel le composant MEMS (200) comporte un actionneur MEMS multicouche, un capteur MEMS multicouche ou un générateur MEMS multicouche, et
dans lequel le composant MEMS présente une séquence de couches à polarisation orientée en alternance.

12. Dispositif MEMS (300), avec
un substrat (310), et
un premier composant MEMS (200) selon l'une des revendications 7 à 11, où la couche passive (231c, 240, 710) du composant MEMS (200) est disposée de manière déformable sur le substrat (310).

13. Dispositif MEMS (300) selon la revendication 12, avec
un deuxième composant MEMS (200) selon l'une des revendications 7 à 11, où la première et la deuxième couche passive (231c, 240, 7 10) sont une communauté et les électrodes et les couches ferroélectriques du premier et du deuxième composant MEMS (200) sont disposées en parallèle.

14. Procédé de fabrication d'un composant MEMS (200), aux étapes suivantes consistant à:
empiler une première électrode (232, 720), une première couche ferroélectrique (210, 730), une deuxième électrode (230, 722), une deuxième couche piézoélectrique (212, 732) et une troisième électrode (234), dans cet ordre, où la première couche ferroélectrique (210, 730) et la deuxième couche piézoélectrique (212, 732) présentent la même direction de polarisation (140, 142, 260, 640, 740, 740a, 740b, 780) et où au moins la première couche ferroélectrique (210, 730) comporte du matériau ferroélectrique (100) avec un cristal mixte (110) qui comporte de l'AIN (120) et au moins un nitrure d'un métal de transition (130);
dans lequel la part du nitrure du métal de transition (130) est choisie de sorte qu'une direction d'une polarité (140, 142, 260, 640, 740, 740a, 740b, 780) du matériau ferroélectrique (100) puisse être commutée par application d'une tension de commutation (150), dans lequel la tension de commutation (150) se situe au-dessous d'une tension de claquage du matériau ferroélectrique (100); et
dans lequel le procédé présente par ailleurs l'étape suivante consistant à:
appliquer une tension de commutation (150) à la première électrode (232, 720) et à la deuxième électrode (230, 722), où la direction de polarisation (140, 142, 260, 640, 740, 740a, 740b, 780) de la première couche ferroélectrique (210, 730) est inversée, de sorte que soit inversée la direction de polarisation (140, 142, 260, 640, 740, 740a, 740b, 780) de la première couche ferroélectrique (210, 730).

15. Procédé selon la revendication 14,
dans lequel la première électrode (232, 720), la première couche ferroélectrique (210, 730), la deuxième électrode (230, 722), la deuxième couche piézoélectrique (212, 732) et la troisième électrode (234) sont empilées sur un substrat (310), et
dans lequel le procédé comporte par ailleurs l'étape suivante consistant à:
intégrer un ou plusieurs composants de circuit d'un circuit intégré à l'aide d'un processus CMOS dans le substrat (310) avant ou après l'empilement de la première électrode (232, 720), de la première couche ferroélectrique (210, 730), de la deuxième électrode (230, 722), de la deuxième couche piézoélectrique (212, 732) et de la troisième électrode (234), et
dans lequel le substrat est connecté par exemple soit à la première électrode, soit à la troisième électrode.
